# EUROPEAN PATENT APPLICATION

(11) **EP 4 456 125 A2**
(43) Date of publication of application: **30.10.2024**
(21) Application number: 23218879.7
(22) Date of filing: 20.12.2023
(51) Int. Cl.: H01L 21/8238, H01L 21/285, H01L 27/092, H01L 29/06, H01L 29/08, H01L 29/417, H01L 29/45, H01L 29/66, H01L 29/775, H01L 29/786

(54) **SEMICONDUCTOR DEVICE AND METHOD OF FABRICATING THE SAME**

(30) Priority: 27.04.2023 KR 20230055096
(71) Applicant: Samsung Electronics Co., Ltd., Suwon-si, Gyeonggi-do 16677 (KR)
(72) Inventor: YOO, Jongryeol, 16677 Suwon-si (KR)
(74) Representative: Marks & Clerk LLP

(57) **Abstract**

The present disclosure relates to semiconductor devices and their fabrication methods. One example semiconductor device comprises a substrate (100) that includes an active region, an active pattern on the active region, a source/drain pattern (SD1, SD2) on the active pattern, an active contact (AC) that extends from a top surface to a sidewall of the source/drain pattern and includes a first part (AC1) that covers the sidewall of the source/drain pattern and a second part (AC2) that covers the top surface of the source/drain pattern, a first layer (L1) between the source/drain pattern and the first part, and a second layer (L2) separated from the first layer and across the first part. Each of the first layer and the second layer includes a silicide layer.

## Description

### BACKGROUND

A semiconductor device includes an integrated circuit including metal oxide semiconductor field effect transistors (MOSFETs). As sizes and design rules of the semiconductor device are gradually decreased, sizes of the MOSFETs are also increasingly scaled down. The scale down of MOSFETs may cause a deterioration of operating characteristics of the semiconductor device. Accordingly, various studies have been conducted to develop methods of fabricating semiconductor devices having superior performances while overcoming limitations caused by high integration and/or reduced size of the semiconductor devices.

### SUMMARY

The present disclosure relates to semiconductor devices with increased reliability and improved electrical properties, as well as methods of fabricating a semiconductor device with increased reliability and improved electrical properties.

In some implementations, a semiconductor device may comprise: a substrate that includes an active region; an active pattern on the active region; a source/drain pattern on the active pattern; an active contact that extends from a top surface to a sidewall of the source/drain pattern, wherein the active contact includes a first part that covers the sidewall of the source/drain pattern and a second part that covers the top surface of the source/drain pattern; a first layer between the source/drain pattern and the first part; and a second layer spaced apart (or separated) from the first layer and across the first part. Each of the first layer and the second layer may include a silicide layer.

In some implementations, a semiconductor device may comprise: a substrate that includes an active region; an active pattern on the active region; a source/drain pattern on the active pattern; and an active contact electrically connected to the source/drain pattern. A sidewall of the source/drain pattern may include a first surface and a second surface. The first surface and the second surface may meet each other or intersect to define a vertex of the source/drain pattern. The active contact may include a first extension that covers the first surface and a second extension that covers the second surface. The first extension may have a first slope and extends along the first surface. The second extension may have a second slope and extends along the second surface. One of the first slope and the second slope may be a positive slope, and the other of the first slope and the second slope may be a negative slope.

In some implementations, a method of fabricating a semiconductor device may comprise: forming an active pattern on a substrate; forming a source/drain pattern on the active pattern; forming a first silicon layer, a sacrificial layer on the first silicon layer, and a second silicon layer on the sacrificial layer, the first silicon layer extending from a top surface to a sidewall of the source/drain pattern; forming a stop layer on the second silicon layer; forming a first interlayer dielectric layer on the active pattern and a second interlayer dielectric layer on the first interlayer dielectric layer; etching the first and second interlayer dielectric layers to form a recess hole; partially removing the stop layer and the second silicon layer that are exposed by the recess hole; removing the sacrificial layer exposed by the recess hole; doping impurities into the first and second silicon layers exposed by the recess hole; forming a silicide layer by depositing a metallic material on the first and second silicon layers that are exposed by the recess hole; and forming an active contact in the recess hole.

At least some of the above and other features of the invention are set out in the claims.

### BRIEF DESCRIPTION OF THE DRAWINGS

FIGS. 1 to 3 illustrate conceptual views showing logic cells of an example of a semiconductor device.
FIG. 4 illustrates a plan view showing an example of a semiconductor device.
FIGS. 5A, 5B, 5C, and 5D illustrate example cross-sectional views respectively taken along lines A-A', B-B', C-C', and D-D' of FIG. 4.
FIG. 6 illustrates an enlarged view showing an example of section M depicte in FIG. 5A.
FIG. 7 illustrates an enlarged view showing an example of section N depicted in FIG. 5B.
FIG. 8 illustrates an enlarged view showing an example of section A depicted in FIG. 5C.
FIGS. 9A to 18 illustrate example cross-sectional views showing a method of fabricating a semiconductor device.
FIG. 19 illustrates an example enlarged view showing section A of FIG. 5C.

### DETAILED DESCRIPTION

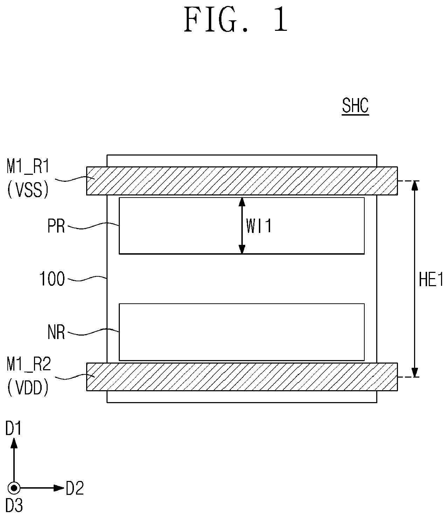

FIGS. 1 to 3 illustrate conceptual views showing logic cells of an example of a semiconductor device.

Referring to FIG. 1, a single height cell SHC may be provided. For example, a substrate 100 may be provided thereon with a first power line M1_R1 and a second power line M1_R2. The first power line M1_R1 may be a path for providing a source voltage VSS, for example, a ground voltage. The second power line M1_R2 may be a path for providing a drain voltage VDD, for example, a power voltage.

The single height cell SHC may be defined between the first power line M1_R1 and the second power line M1_R2. The single height cell SHC may include one first active region and one second active region. One of the first and second active regions may be a PMOSFET region PR, and the other of the first and second active regions may be an NMOSFET region NR. For example, the single height cell SHC may have a complementary metal oxide semiconductor (CMOS) structure provided between the first power line M1_R1 and the second power line M1_R2.

Each of the PMOSFET and NMOSFET regions PR and NR may have a first width W1 in a first direction D1. A first height HE1 may be defined as a length in the first direction D1 of the single height cell SHC. The first height HE1 may be substantially the same as a distance (e.g., pitch) between the first power line M1_R1 and the second power line M1_R2.

The single height cell SHC may constitute one logic cell. In this description, the logic cell may mean a logic device, such as AND, OR, XOR, XNOR, and/or an inverter, that performs a specific function. For example, the logic cell may include transistors for constituting a logic device, and may also include wiring lines that connect the transistors to each other.

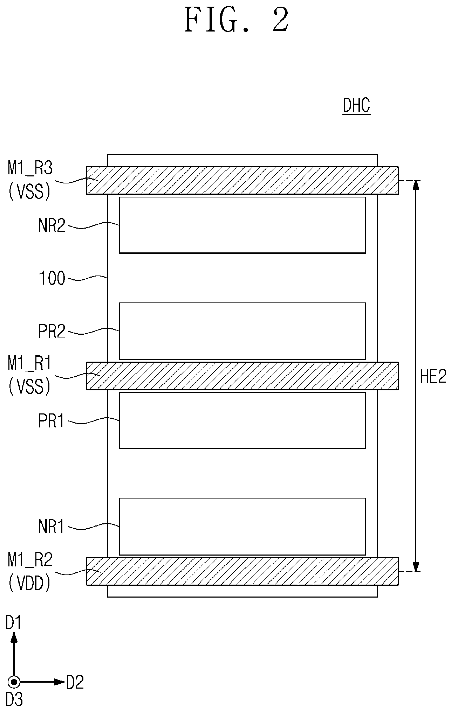

Referring to FIG. 2, a double height cell DHC may be provided. For example, a substrate 100 may be provided thereon with a first power line M1_R1, a second power line M1_R2, and a third power line M1_R3. The first power line M1_R1 may be disposed between the second power line M1_R2 and the third power line M1_R3. The third power line M1_R3 may be a path for providing a source voltage VSS.

The double height cell DHC may be defined between the second power line M1_R2 and the third power line M1_R3. The double height cell DHC may include a first PMOSFET region PR1, a second PMOSFET region PR2, a first NMOSFET region NR1, and a second NMOSFET region NR2.

The first NMOSFET region NR1 may be adjacent to the second power line M1_R2. The second NMOSFET region NR2 may be adjacent to the third power line M1_R3. The first and second PMOSFET regions PR1 and PR2 may be adjacent to the first power line M1_R1. When viewed in plan, the first power line M1_R1 may be disposed between the first and second PMOSFET regions PR1 and PR2.

A second height HE2 may be defined to indicate a length in the first direction D1 of the double height cell DHC. The second height HE2 may be about twice the first height HE1 of FIG. 1. The first and second PMOSFET regions PR1 and PR2 of the double height cell DHC may collectively operate as a single PMOSFET region. Therefore, the double height cell DHC may have a PMOS transistor whose channel size is greater than that of a PMOS transistor included in the single height cell SHC discussed above in FIG. 1.

In some implementations, the double height cell DHC shown in FIG. 2 may be defined as a multi-height cell. Although not shown, the multi-height cell may include a triple height cell whose cell height is about three times that of the single height cell SHC.

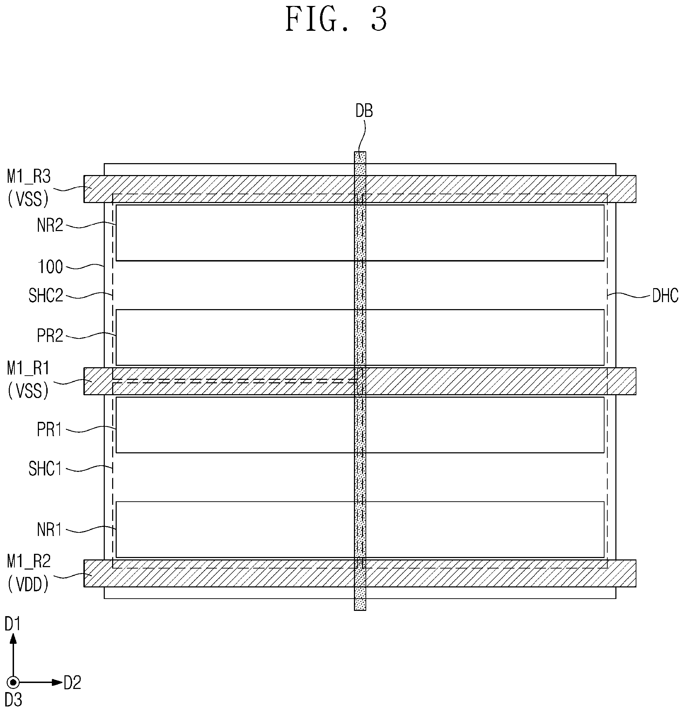

Referring to FIG. 3, a substrate 100 may be provided thereon with a first single height cell SHC1, a second single height cell SHC2, and a double height cell DHC that are two-dimensionally disposed. The first single height cell SHC1 may be disposed between a first power line M1_R1 and a second power line M1_R2. The second single height cell SHC2 may be disposed between the first power line M1_R1 and a third power line M1_R3. The second single height cell SHC2 may be adjacent in a first direction D1 to the first single height cell SHC1.

The double height cell DHC may be disposed between the second power line M1_R2 and the third power line M1_R3. The double height cell DHC may be adjacent in a second direction D2 to the first and second single height cells SHC1 and SHC2.

A separation structure DB may be provided between the first single height cell SHC1 and the double height cell DHC and between the second single height cell SHC2 and the double height cell DHC. The separation structure DB may electrically separate an active region of the double height cell DHC from an active region of each of the first and second single height cells SHC1 and SHC2.

The width (D2) and height (D1) directions in Figure 2 (and other Figures) may correspond to axes lying in the plane of the double height cell DHC. They may both be referred to as horizontal directions. A vertical (D3) direction may be a direction perpendicular to this plane. Accordingly, features that are further along the vertical direction than other features (as shown in subsequent figures) may be considered above the other features. Similarly, features that are less far along the vertical direction than other features may be considered below the other features. Upper features may be further along the vertical direction than lower features. It will be appreciated that the directions referenced herein are relative to the structure of the semiconductor device. Accordingly, the directions need not imply any particular orientation of the semiconductor device during use.

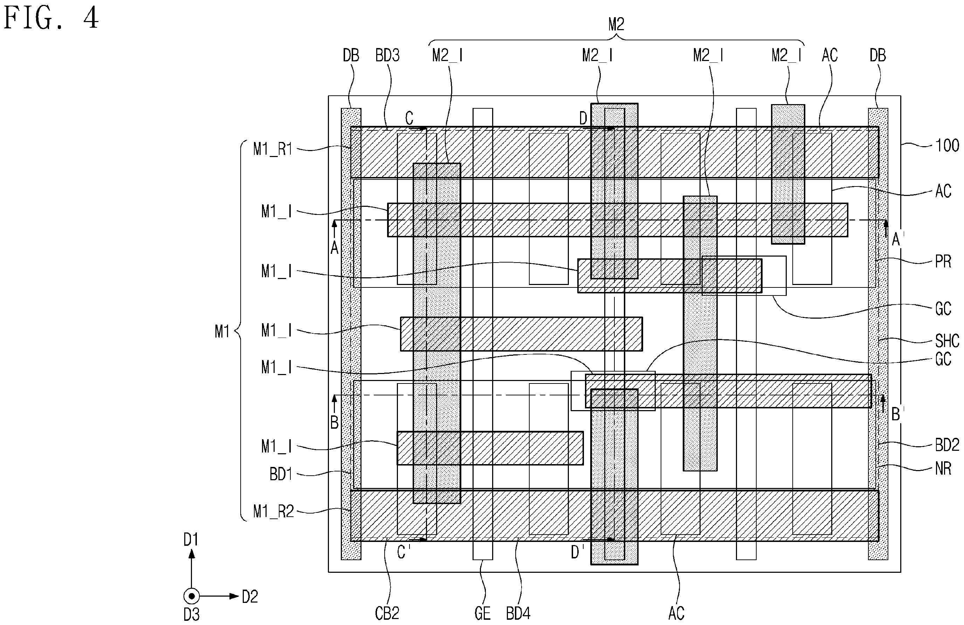

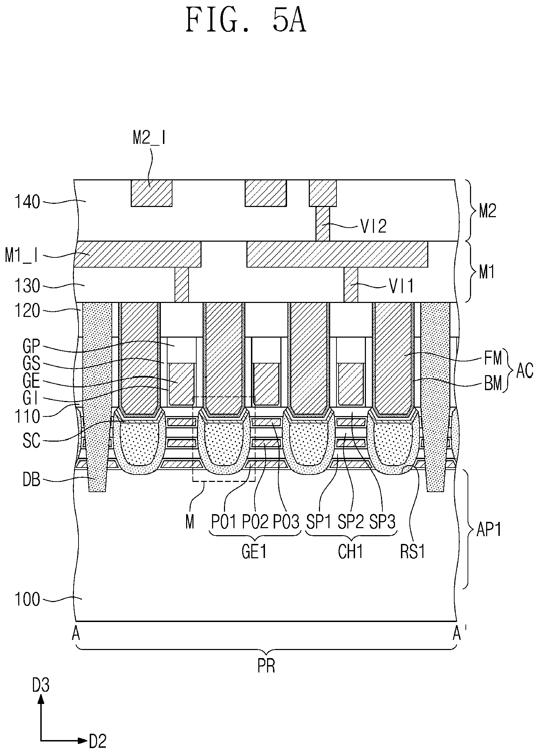

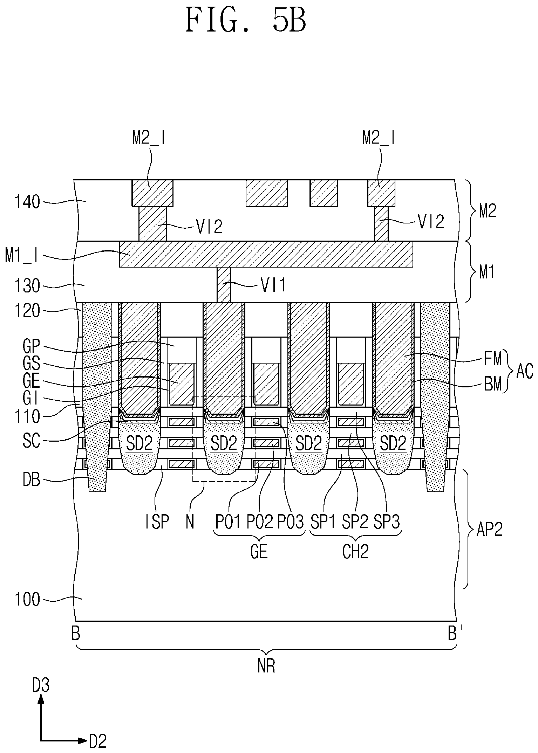

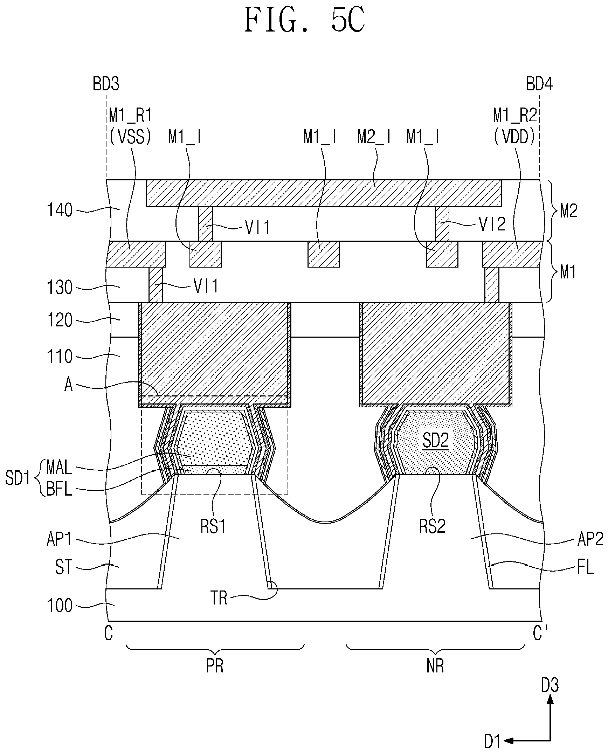

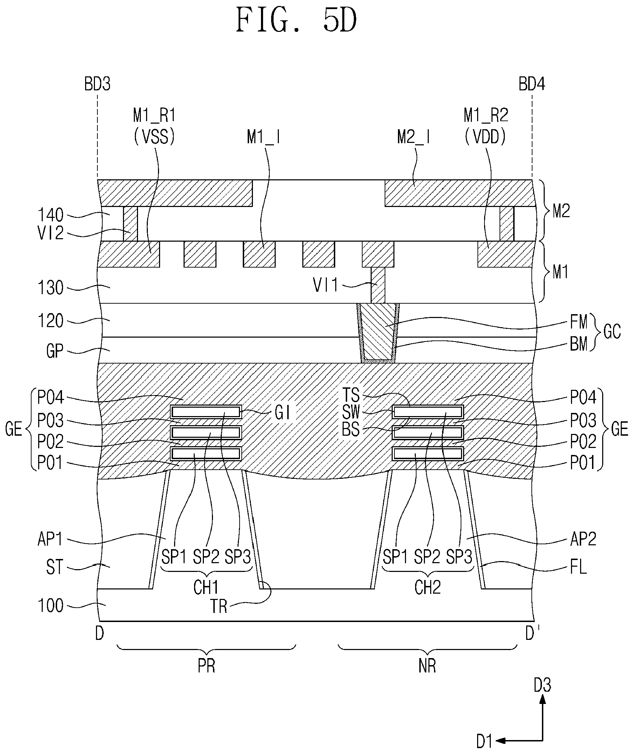

FIG. 4 illustrates a plan view showing an example of a semiconductor device. FIGS. 5A, 5B, 5C, and 5D illustrate example cross-sectional views respectively taken along lines A-A', B-B', C-C', and D-D' of FIG. 4. A semiconductor device depicted in FIGS. 4 and 5A to 5D may be a detailed example of the single height cell SHC shown in FIG. 1.

Referring to FIGS. 4 and 5A to 5D, a single height cell SHC may be provided on a substrate 100. The single height cell SHC may be provided thereon with logic transistors included in a logic circuit. The substrate 100 may be a compound semiconductor substrate or a semiconductor substrate including silicon, germanium, or silicon-germanium. For example, the substrate 100 may be a silicon substrate.

The substrate 100 may include a PMOSFET region PR and an NMOSFET region NR. Each of the PMOSFET region PR and the NMOSFET region NR may extend in a second direction D2.

A first active pattern AP1 and a second active pattern AP2 may be defined by a trench TR formed on an upper portion of the substrate 100. The first active pattern AP1 may be provided on the PMOSFET region PR, and the second active pattern AP2 may be provided on the NMOSFET region NR. The first and second active patterns AP1 and AP2 may extend in the second direction D2. The first and second active patterns AP1 and AP2 may be vertically protruding portions of the substrate 100.

A device isolation layer ST may be provided on the substrate 100. The device isolation layer ST may partially or completely fill the trench TR. The device isolation layer ST may include a silicon oxide layer. The device isolation layer ST may, in some examples, not cover any of first and second channel patterns CH1 and CH2 which will be discussed below.

A liner layer FL may be interposed between the device isolation layer ST and each of the first and second active patterns AP1 and AP2. The liner layer FL may directly cover a sidewall of each of the first and second active patterns AP1 and AP2. For example, the liner layer FL may directly cover a sidewall of the trench TR. The liner layer FL may directly cover a bottom surface of the trench TR. For example, the liner layer FL may include a silicon oxide layer, a silicon nitride layer, or a combination thereof.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 that are sequentially stacked. The first, second, and third semiconductor patterns SP1, SP2, and SP3 may be spaced apart from each other in a third direction D3, which may for example be a vertical direction relative to the device as explained above. Use herein of vertical directional terms such as "upper", "lower" and so on may be considered in terms of this vertical direction. In terms of this direction, the first semiconductor pattern SP1 may be formed at bottom of the semiconductor patterns SP1 to SP3 (i.e. physically closer to the respective one of the first and second channel patterns CH1, CH2), and the third semiconductor pattern SP3 may be formed at top of the semiconductor patterns SP1 to SP3 (i.e. physically further from the respective one of the first and second channel patterns CH1, CH2).

Each of the first, second, and third semiconductor patterns SP1, SP2, and SP3 may include silicon (Si), germanium (Ge), or silicon-germanium (SiGe). For example, each of the first, second, and third semiconductor patterns SP1, SP2, and SP3 may include crystalline silicon, for example, monocrystalline silicon. In some implementations, the first, second, and third semiconductor patterns SP1, SP2, and SP3 may be stacked nano-sheets. A nanosheet may be a sheet having a thickness in a scale ranging from 1 to 100nm.

A plurality of first source/drain patterns SD1 may be provided on the first active pattern AP1. A plurality of first recesses RS 1 may be formed on an upper portion of the first active pattern AP1. The first source/drain patterns SD1 may be correspondingly provided in the first recesses RS1. The first source/drain patterns SD1 may be impurity regions having a first conductivity type (e.g., p-type). The first channel pattern CH1 may be interposed between a pair of first source/drain patterns SD1. For example, the pair of first source/drain patterns SD1 may be connected through the stacked first, second, and third semiconductor patterns SP1, SP2, and SP3. In the implementations illustrated herein, the phrase source/drain pattern may be understood to mean a source terminal pattern or a drain terminal pattern of a transistor.

A plurality of second source/drain patterns SD2 may be provided on the second active pattern AP2. A plurality of second recesses RS2 may be formed on an upper portion of the second active pattern AP2. The second source/drain patterns SD2 may be correspondingly provided in the second recesses RS2. The second source/drain patterns SD2 may be impurity regions having a second conductivity type (e.g., n-type). The second channel pattern CH2 may be interposed between a pair of second source/drain patterns SD2. For example, the pair of second source/drain patterns SD2 may be connected through the stacked first, second, and third semiconductor patterns SP1, SP2, and SP3.

The first and second source/drain patterns SD1 and SD2 may be epitaxial patterns formed by a selective epitaxial growth (SEG) process. For example, each of the first and second source/drain patterns SD1 and SD2 may have a top surface higher than that of the third semiconductor pattern SP3. For another example, at least one of the first and second source/drain patterns SD1 and SD2 may have a top surface at substantially the same level as that of a top surface of the third semiconductor pattern SP3.

In some implementations, the first source/drain patterns SD1 may include a semiconductor element whose lattice constant is greater than that of a semiconductor element of the substrate 100. For example, the first source/drain patterns SD1 may include one or both of silicon (Si) and silicon-germanium (SiGe). Therefore, a pair of first source/drain patterns SD1 may provide the first channel pattern CH1 with compressive stress. The second source/drain patterns SD2 may include the same semiconductor element as that of the substrate 100. For example, the second source/drain patterns SD2 may include one or both of silicon-arsenic (SiAs) and silicon-phosphorus (SiP).

In some implementations, the first source/drain pattern SD1 may have an uneven embossing shape on a sidewall thereof. For example, the sidewall of the first source/drain pattern SD1 may have a wavy profile. The sidewall of the first source/drain pattern SD1 may protrude toward first, second, and third parts PO1, PO2, and PO3 of a gate electrode GE which will be discussed below.

Gat electrodes GE may be provided on the first and second channel patterns CH1 and CH2. Each of the gate electrodes GE may extend in the first direction D1, while running across the first and second channel patterns CH1 and CH2. Each of the gate electrodes GE may vertically overlap the first and second channel patterns CH1 and CH2. The gate electrodes GE may be arranged at a first pitch in the second direction D2.

The gate electrode GE may include a first part PO1 interposed between the first semiconductor pattern SP1 and the active pattern AP1 or AP2, a second part PO2 interposed between the first semiconductor pattern SP1 and the second semiconductor pattern SP2, a third part PO3 interposed between the second semiconductor pattern SP2 and the third semiconductor pattern SP3, and a fourth part PO4 on the third semiconductor pattern SP3.

Referring to FIG. 5D, the gate electrode GE may be provided on a top surface TS, a bottom surface BS, and opposite sidewalls SW of each of the first, second, and third semiconductor patterns SP1, SP2, and SP3. For example, a transistor may be a three-dimensional field effect transistor (e.g., MBCFET or GAAFET) in which the gate electrode GE three-dimensionally surrounds the first and second channel patterns CH1 and CH2.

On the NMOSFET region NR, inner spacers ISP may be correspondingly interposed between the second source/drain pattern SD2 and the first, second, and third parts PO1, PO2, and PO3. Each of the first, second, and third parts PO1, PO2, and PO3 of the gate electrode GE may be spaced apart from the second source/drain pattern SD2 across the inner spacer ISP. The inner spacer ISP may prevent a leakage current from the gate electrode GE.

Referring to FIGS. 4 and 5A to 5D, a pair of gate spacers GS may be disposed on opposite sidewalls of the fourth part PO4 of the gate electrode GE. The gate spacers GS may extend in the first direction D1 along the gate electrode GE. The gate spacers GS may have their top surfaces higher than that of the gate electrode GE. The top surfaces of the gate spacers GS may be coplanar with that of a first interlayer dielectric layer 110 which will be discussed below. In an example, the gate spacers GS may include at least one selected from SiCN, SiCON, and SiN. In another example, the gate spacers GS may include a multiple layer formed of at least two selected from SiCN, SiCON, and SiN.

A gate capping pattern GP may be provided on the gate electrode GE. The gate capping pattern GP may extend in the first direction D1 along the gate electrode GE. The gate capping pattern GP may include a material having an etch selectivity with respect to first and second interlayer dielectric layers 110 and 120 which will be discussed below. For example, the gate capping pattern GP may include at least one selected from SiON, SiCN, SiCON, and SiN.

A gate dielectric layer GI may be interposed between the gate electrode GE and the first channel pattern CH1 and between the gate electrode GE and the second channel pattern CH2. The gate dielectric layer GI may cover the top surface TS, the bottom surface BS, and the opposite sidewalls SW of each of the first, second, and third semiconductor patterns SP1, SP2, and SP3. The gate dielectric layer GI may cover a top surface of the device isolation layer ST below the gate electrode GE.

In some implementations, the gate dielectric layer GI may include one or more of a silicon oxide layer, a silicon oxynitride layer, and a high-k dielectric layer. The high-k dielectric layer may include a high-k dielectric material whose dielectric constant is greater than that of a silicon oxide layer. For example, the high-k dielectric material may include one or more of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

The gate electrode GE may include a first electrode pattern and a second electrode pattern on the first electrode pattern. The first electrode pattern may be provided on the gate dielectric layer GI to be adjacent to the first, second, and third semiconductor patterns SP1, SP2, and SP3. The first electrode pattern may include a work-function metal that adjusts a threshold voltage of a transistor. A work-function metal, in the present context, may be a metal selected to have a work function that serves to adjust the threshold voltage of the transistor in the described manner. A thickness and composition of the first electrode pattern may be adjusted to achieve a desired threshold voltage of a transistor. For example, the first, second, and third parts PO1, PO2, and PO3 of the gate electrode GE may be formed of the first electrode pattern or a work-function metal.

The first electrode pattern may include a metal nitride layer. For example, the first electrode pattern may include nitrogen (N) and at least one metal selected from titanium (Ti), tantalum (Ta), aluminum (Al), tungsten (W), and molybdenum (Mo). In addition, the first electrode pattern may further include carbon (C). The first electrode pattern may include a plurality of stacked work-function metal layers.

The second electrode pattern may include metal whose resistance is less than that of the first electrode pattern. For example, the second electrode pattern may include at least one metal selected from tungsten (W), aluminum (Al), titanium (Ti) and tantalum (Ta). For example, the fourth part PO4 of the gate electrode GE may include a first electrode pattern and a second electrode pattern on the first electrode pattern.

A first interlayer dielectric layer 110 may be provided on the substrate 100. The first interlayer dielectric layer 110 may cover the gate spacers GS and the first and second source/drain patterns SD1 and SD2. The first interlayer dielectric layer 110 may have a top surface substantially coplanar with that of the gate capping pattern GP and that of the gate spacer GS. The first interlayer dielectric layer 110 may be provided thereon with a second interlayer dielectric layer 120 that covers the gate capping pattern GP. A third interlayer dielectric layer 130 may be provided on the second interlayer dielectric layer 120. A fourth interlayer dielectric layer 140 may be provided on the third interlayer dielectric layer 130. For example, the first to fourth interlayer dielectric layers 110 to 140 may include a silicon oxide layer.

The single height cell SHC may have a first boundary BD1 and a second boundary BD2 that are opposite to each other in the second direction D2. The first and second boundaries BD1 and BD2 may extend in the first direction D1. The single height cell SHC may have a third boundary BD3 and a fourth boundary BD4 that are opposite to each other in the first direction D1. The third and fourth boundaries BD3 and BD4 may extend in the second direction D2.

The single height cell SHC may be provided on its opposite sides with a pair of separation structures DB that are opposite to each other in the second direction D2. For example, the pair of separation structures DB may be correspondingly provided on first and second boundaries BD1 and BD2 of the single height cell SHC. The separation structure DB may extend in the first direction D1 parallel to the gate electrodes GE. A pitch between the separation structure DB and its adjacent gate electrode GE may be the same as the first pitch.

The separation structure DB may penetrate the first and second interlayer dielectric layers 110 and 120, and may extend into the first and second active patterns AP1 and AP2. The separation structure DB may penetrate an upper portion of each of the first and second active patterns AP1 and AP2. The separation structure DB may electrically separate an active region of the single height cell SHC from an active region of an adjacent another cell.

Active contacts AC may be provided to penetrate the first and second interlayer dielectric layers 110 and 120 to come into electrical connection with the first and second source/drain patterns SD1 and SD2. A pair of active contacts AC may be provided on opposite sides of the gate electrode GE. When viewed in plan, the active contact AC may have a bar shape that extends in the first direction D1.

The active contact AC may be a self-aligned contact. A self-aligned contact may utilize a protective dielectric layer over a transistor gate, which allows closer packing of components without contact-to-gate shorts. For example, the gate capping pattern GP and the gate spacer GS may be used to form the active contact AC in a self-alignment manner. The active contact AC may cover, for example, at least a portion of a sidewall of the gate spacer GS. Although not shown, the active contact AC may cover a portion of the top surface of the gate capping pattern GP.

Gate contacts GC may be provided to penetrate the second interlayer dielectric layer 120 and the gate capping pattern GP to come into electrical connection with the gate electrodes GE. When viewed in plan, the gate contacts GC may be disposed to correspondingly overlap the PMOSFET region PR and the NMOSFET region NR. For example, the gate contact GC may be provided on the second active pattern AP2.

The gate contact GC may include a conductive pattern FM and a barrier pattern BM that surrounds the conductive pattern FM. For example, the conductive pattern FM may include at least one metal selected from aluminum, copper, tungsten, molybdenum, and cobalt. The barrier pattern BM may cover sidewalls and a bottom surface of the conductive pattern FM. The barrier pattern BM may include a metal layer and a metal nitride layer. The metal layer may include at least one selected from titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

A first metal layer M1 may be provided in the third interlayer dielectric layer 130. For example, the first metal layer M1 may include a first power line M1_R1, a second power line M1_R2, and first wiring lines M1_I. The lines M1_R1, M1_R2, and M1_I of the first metal layer M1 may extend in parallel to each other in the second direction D2.

For example, the first and second power lines M1_R1 and M1_R2 may be respectively provided on the third and fourth boundaries BD3 and BD4 of the single height cell SHC. The first power line M1_R1 may extend in the second direction D2 along the third boundary BD3. The second power line M1_R2 may extend in the second direction D2 along the fourth boundary BD4.

The first wiring lines M1_I of the first metal layer M1 may be disposed between the first and second power lines M1_R1 and M1_R2. The first wiring lines M1_I of the first metal layer M1 may be arranged at a second pitch along the first direction D1. The second pitch may be less than the first pitch. Each of the first wiring lines M1_I may have a line-width less than that of each of the first and second power lines M1_R1 and M1_R2.

The first metal layer M1 may further include first vias VI1. The first vias VI1 may be correspondingly provided below the lines M1_R1, M1_R2, and M1_I of the first metal layer M1. The first via VI1 may electrically connect the active contact AC to a wiring line of the first metal layer M1. The first via VI1 may electrically connect the gate contact GC to a wiring line of the first metal layer M1.

A given line and its underlying first via VI1 of the first metal layer M1 may be formed by individual processes. For example, the given line and its underlying first via VI1 of the first metal layer M1 may each be formed by a single damascene process. In a single damascene process, a given line and its corresponding via are formed one at a time. A sub-20 nm process may be employed to fabricate a semiconductor device.

A second metal layer M2 may be provided in the fourth interlayer dielectric layer 140. The second metal layer M2 may include a plurality of second wiring lines M2_I. The second wiring lines M2_I of the second metal layer M2 may each have a linear or bar shape that extends in the first direction D1. For example, the second wiring lines M2_I may parallel extend in the first direction D1.

The second metal layer M2 may further include second vias VI2 that are correspondingly provided below the second wiring lines M2_I. A certain line of the first metal layer M1 may be electrically through the second via VI2 to a corresponding line of the second metal layer M2. For example, a wiring line and its underlying second via VI2 of the second metal layer M2 may be simultaneously formed in a dual damascene process. In a dual damascene process, a wiring line and its corresponding via are formed simultaneously, in contrast with a single damascene process.

The first and second metal layers M1 and M2 may have their wiring lines that include the same or different conductive materials. For example, the wiring lines of the first and second metal layers M1 and M2 may include at least one metallic material, for example one or more of aluminum, copper, tungsten, molybdenum, ruthenium, and cobalt. Although not shown, other metal layers (e.g., M3, M4, M5, etc.) may be additionally stacked on the fourth interlayer dielectric layer 140. Each of the stacked metal layers may include wiring lines for routing between cells.

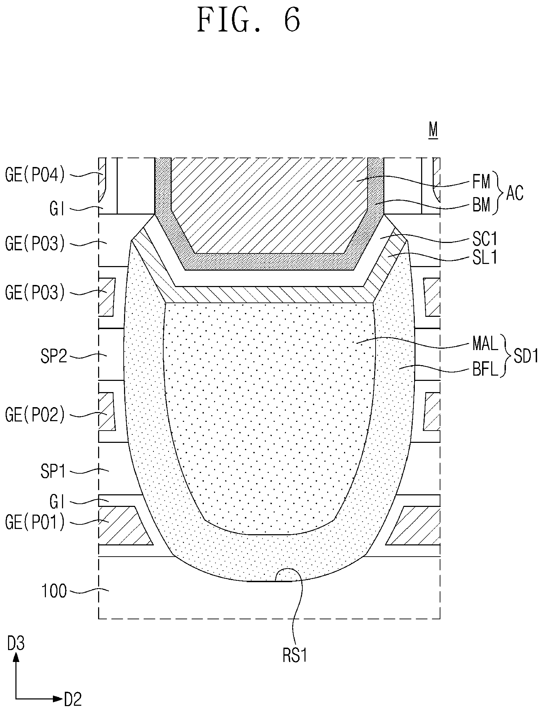

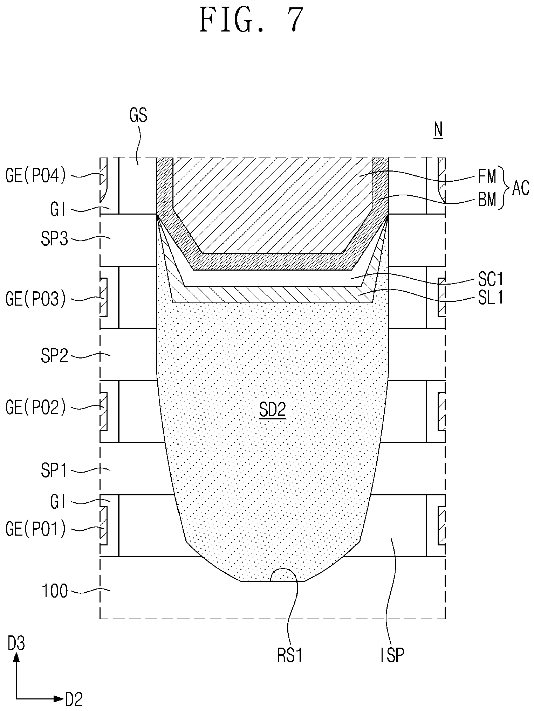

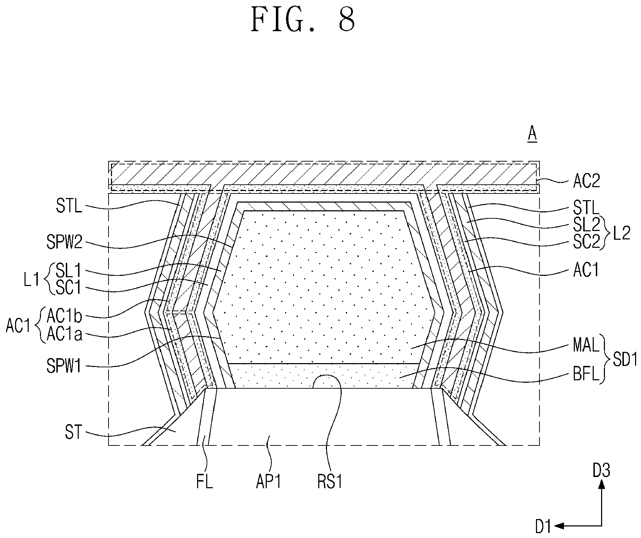

The active contact AC and the first and second source/drain patterns SD1 and SD2 will be further discussed in detail below with reference to FIGS. 6, 7, and 8. FIG. 6 illustrates an enlarged view showing an example of section M depicted in FIG. 5A. FIG. 7 illustrates an enlarged view showing an example of section N depicted in FIG. 5B. FIG. 8 illustrates an enlarged view showing an example of section A depicted in FIG. 5C.

Referring to FIG. 6, the first source/drain pattern SD1 may include a buffer layer BFL and a main layer MAL on the buffer layer BFL. The buffer layer BFL may cover an inner wall of the first recess RS 1. The buffer layer BFL may have a U shape along a profile of the first recess RS 1.

The buffer layer BFL may include a semiconductor element (e.g., SiGe) whose lattice constant is greater than that of a semiconductor element of the substrate 100. The buffer layer BFL may contain germanium (Ge) whose concentration is relatively low. In some implementations, the buffer layer BFL may not include germanium (Ge), but include only silicon (Si). For example, the germanium concentration of the buffer layer BFL may range from about 0 at% to about 30 at%, for example it may be greater than or equal to 0 at% and less than or equal to 30 at%. The main layer MAL may contain germanium (Ge) whose concentration is relatively high. The germanium concentration of the main layer MAL may be greater than that of the buffer layer BFL. For example, the germanium concentration of the main layer MAL may range from about 30 at% to about 70 at%.

The active contact AC may be formed on the first source/drain pattern SD1. A bottom surface of the active contact AC may be lower than a top surface of the uppermost semiconductor pattern SP3. A lower portion of the active contact AC may be provided in the first recess RS 1. A first silicon layer SL1 and a first silicide layer SC1 may be provided between the first source/drain pattern SD1 and the active contact AC. For example, the first silicon layer SL1 may be provided on the buffer layer BFL and the main layer MAL. The first silicide layer SC1 may be provided between the first silicon layer SL1 and the active contact AC.

The active contact AC may be electrically connected through the first silicide layer SC1 to the first source/drain pattern SD1. The first silicide layer SC1 may include at least one of titanium-silicide, tantalum-silicide, tungsten-silicide, nickel-silicide, and cobalt-silicide. The first silicide layer SC1 may be doped with impurities. The first silicide layer SC1 may have an impurity concentration that increases with decreasing distance from the active contact AC. The first silicon layer SL1 and the first source/drain pattern SD1 may also be doped with impurities, and each of the first silicon layer SL1 and the first source/drain pattern SD1 may have an impurity concentration that increases with decreasing distance from the first silicide layer SC1. The impurities may include at least one of boron (B), gallium (Ga), and indium (In).

Referring to FIG. 8, the active contact AC may extend from a top surface toward opposite sidewalls of the first source/drain pattern SD1. The active contact AC may have a wrap-around structure that covers the top surface and the opposite sidewalls of the first source/drain pattern SD1. For example, the active contact AC may wrap around the top surface and sidewalls of the first source/drain pattern SD1 to completely, or substantially completely, cover or surround said top surface and sidewalls, whilst not covering or surrounding the bottom surface of the first source/drain pattern SD1.

The sidewall of the first source/drain pattern SD1 may have a first surface SPW1 and a second surface SPW2. The first surface SPW1 and the second surface SPW2 may meet each other to define a vertex of the first source/drain pattern SD1. The first surface SPW1 and the second surface SPW2 may have their slopes one of which is a positive slope and the other of which is a negative slope.

The active contact AC may include a first extension AC1a that covers the first surface SPW1 and a second extension AC1b that covers the second surface SPW2. The first extension ACla may extend along the first surface SPW1 while having a first slope, and the second extension AClb may extend along the second surface SPW2 while having a second slope. One of the first and second slopes may be a positive slope, and the other of the first and second slopes may be a negative slope. Thus, the active contact AC may extend along the opposite sidewalls of the first source/drain pattern SD1.

The active contact AC may include a first part AC1 that covers the opposite sidewalls of the first source/drain pattern SD1 and a second part AC2 that covers the top surface of the first source/drain pattern SD1. A first layer L1 may be provided between the first source/drain pattern SD1 and the active contact AC. The first layer L1 may include a first silicon layer SL1 and a first silicide layer SC1 on the first silicon layer SL1. The first silicon layer SL1 may cover the top surface and the opposite sidewalls of the first source/drain pattern SD1. The first silicide layer SC1 may cover a top surface and opposite sidewalls of the first silicon layer SL1.

A second layer L2 may be provided which is spaced apart from the first layer L1 across the first part AC1. The second layer L2 may include a second silicide layer SC2 and a second silicon layer SL2 on the second silicide layer SC2. The second silicide layer SC2 may cover an outer sidewall of the first part AC1. The outer sidewall of the first part AC1 may be a surface opposite to that by which the first part AC1 is in contact with the first layer L1. The second silicon layer SL2 may cover an outer sidewall of the second silicide layer SC2. The outer sidewall of the second silicide layer SC2 may be a surface opposite to that by which the second silicide layer SC2 is in contact with the first part AC 1.

A stop layer STL may be provided on an outer sidewall of the second layer L2. The outer sidewall of the second layer L2 may be a wall opposite to that by which the second layer L2 is in contact with the active contact AC. The stop layer STL may include a silicon nitride (SiN) layer. Likewise the first and second extensions ACla and AClb of the active contact AC, each of the first layer L1, the second layer L2, and the stop layer STL may extend along the opposite sidewalls of the first source/drain pattern SD1.

The active contact AC may include a conductive pattern FM and a barrier pattern BM that surrounds the conductive pattern FM. The barrier pattern BM may be provided between the conductive pattern FM and the first layer L1 and between the conductive pattern FM and the second layer L2. The barrier pattern BM may cover a top surface and opposite sidewalls of the first silicide layer SC1.

For example, the conductive pattern FM may include at least one metal, for example one or more of aluminum, copper, tungsten, molybdenum, and cobalt. The barrier pattern BM may cover sidewalls and a bottom surface of the conductive pattern FM. The barrier pattern BM may include a metal layer and a metal nitride layer. The metal layer may include at least one of titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

Referring to FIG. 7, the active contact AC on the second source/drain pattern SD2 may include the same technical features as those of the active contact AC on the first source/drain pattern SD1. In contrast, impurities of the first silicide layer SC1 on the second source/drain pattern SD2 may include at least one of arsenic (As), phosphorus (P), and antimony (Sb).

In some implementations, the active contact AC may cover the top surface and the opposite sidewalls of each of the first and second source/drain patterns SD1 and SD2. For example, the active contact AC may completely, or substantially completely, cover the top surface and the opposite sidewalls. Thus, each of the source/drain patterns SD1, SD2 may have their top surface and sidewalls, but not their bottom surface, completely or substantially completely covered or surrounded by the active contact AC. Thus, an increased contact area may be provided between the active contact AC and each of the first and second source/drain patterns SD1 and SD2, and this configuration may reduce a contact resistance between the active contact AC and each of the first and second source/drain patterns SD1 and SD2. The first layer L1 may be formed between the active contact AC and each of the first and second source/drain patterns SD1 and SD2, and the second layer L2 may be formed spaced apart from each of the first and second source/drain patterns SD1 and SD2 across the active contact AC. Each of the first and second silicide layers SC1 and SC2 may be doped with impurities, and thus the contact resistance may be further reduced between the active contact AC and each of the first and second source/drain patterns SD1 and SD2. As a result, a semiconductor device may have increased reliability and improved electrical properties.

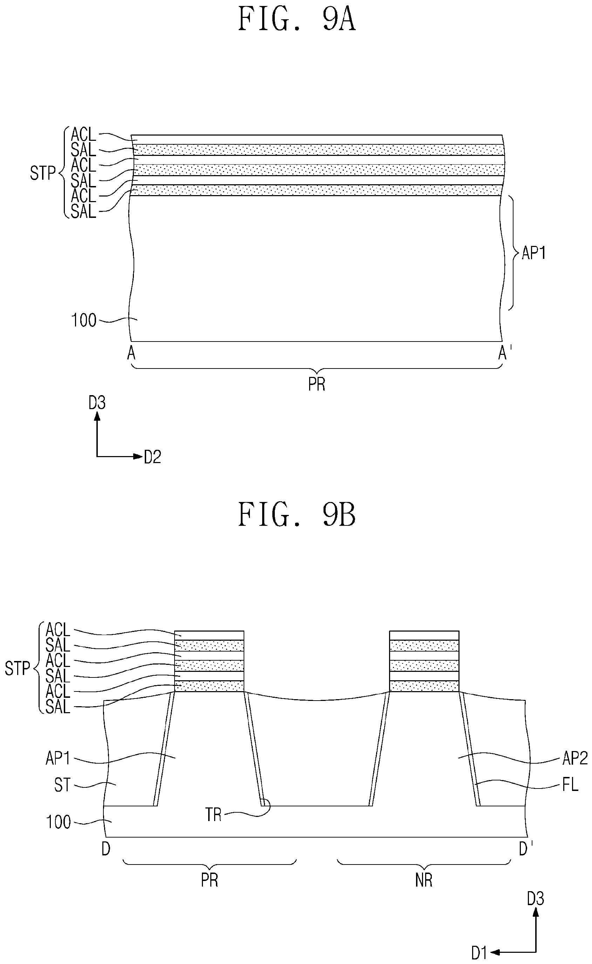

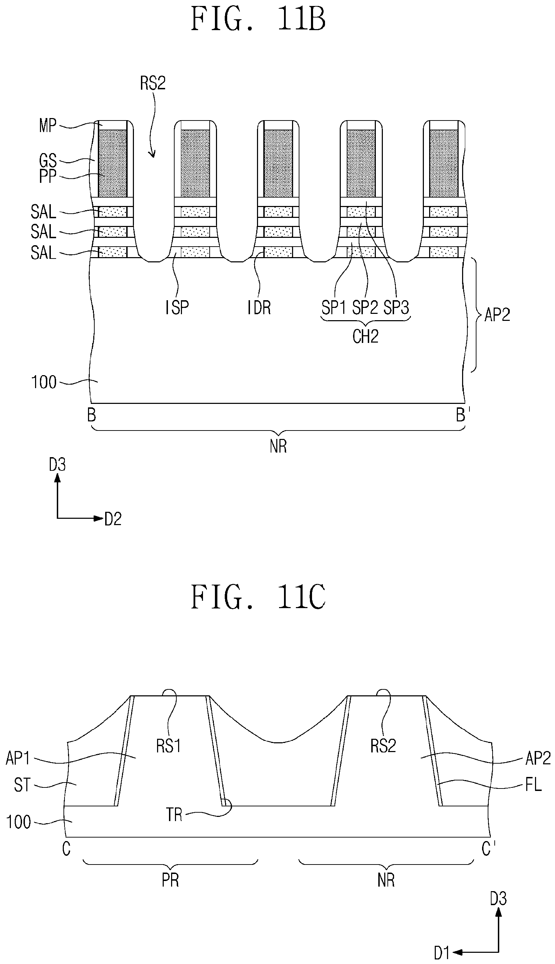

FIGS. 9A to 18 illustrate example cross-sectional views showing a method of fabricating a semiconductor device. FIGS. 9A, 10A, 11A, 12A, 13A, and 14A illustrate cross-sectional views taken along line A-A' of FIG. 4. FIGS. 11B, 12B, 13B, and 14B illustrate cross-sectional views taken along line B-B' of FIG. 4. FIGS. 11C, 12C, 13C, 14C, 15A, 16A, and 18 illustrate cross-sectional views taken along line C-C' of FIG. 4. FIGS. 9B, 10B, 13D, and 14D illustrate cross-sectional views taken along line D-D' of FIG. 4.

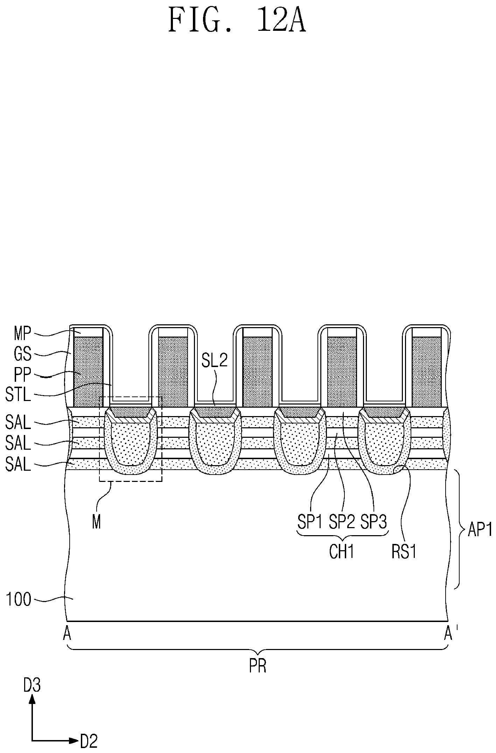

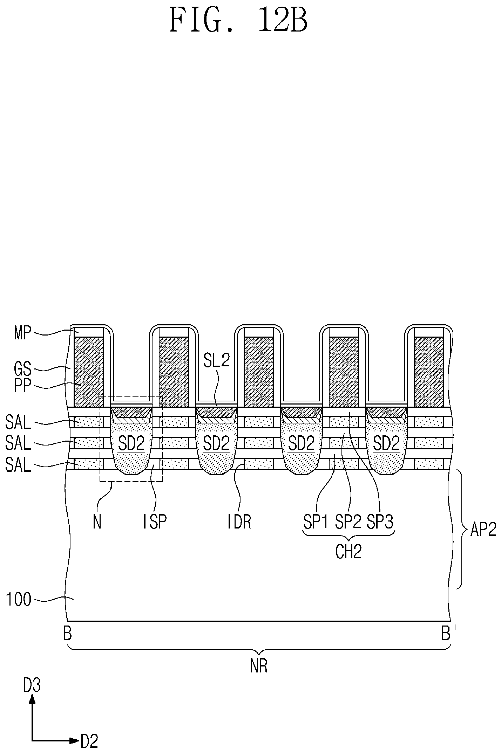

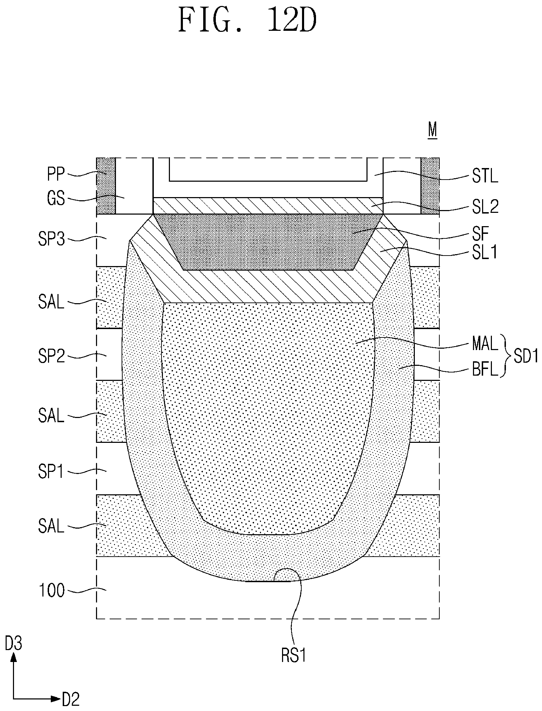

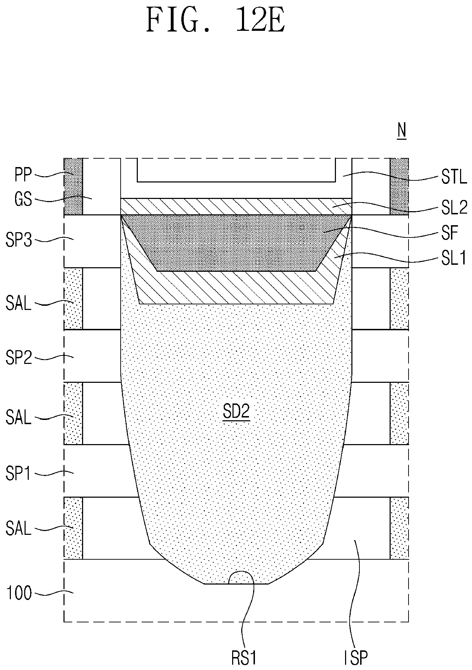

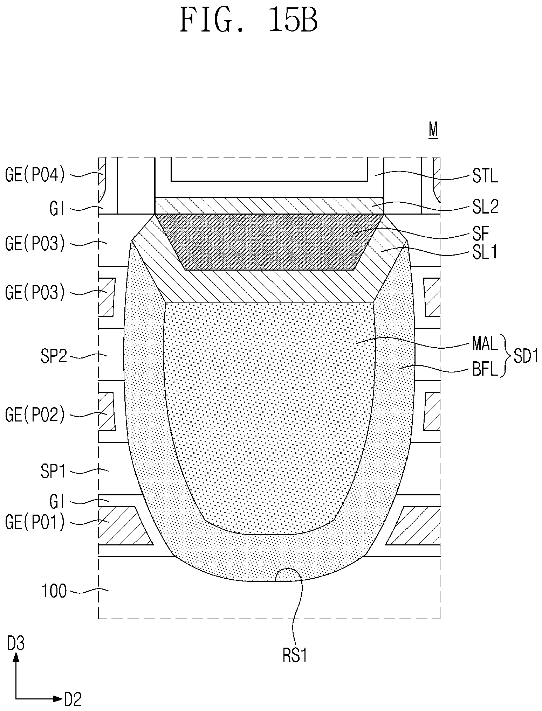

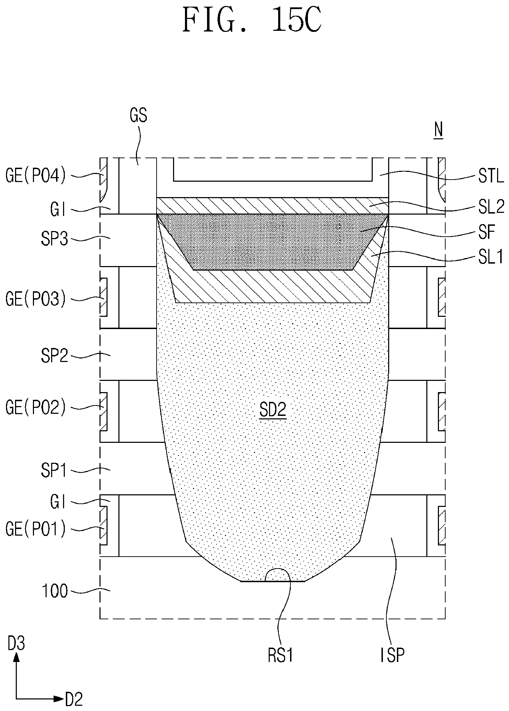

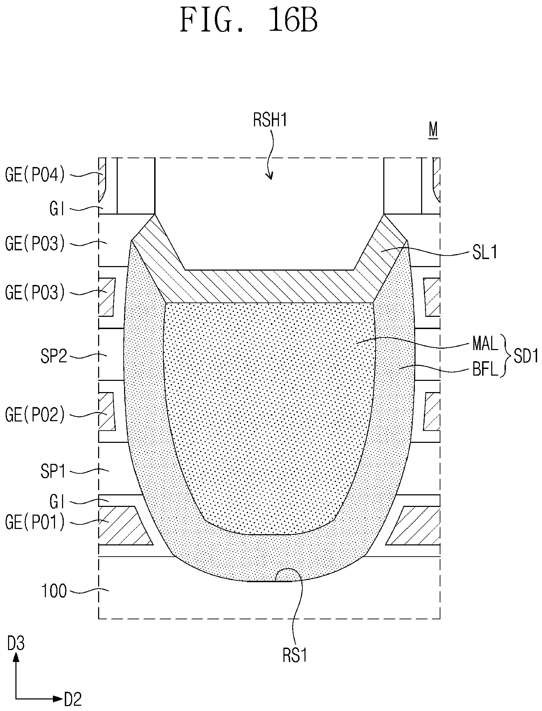

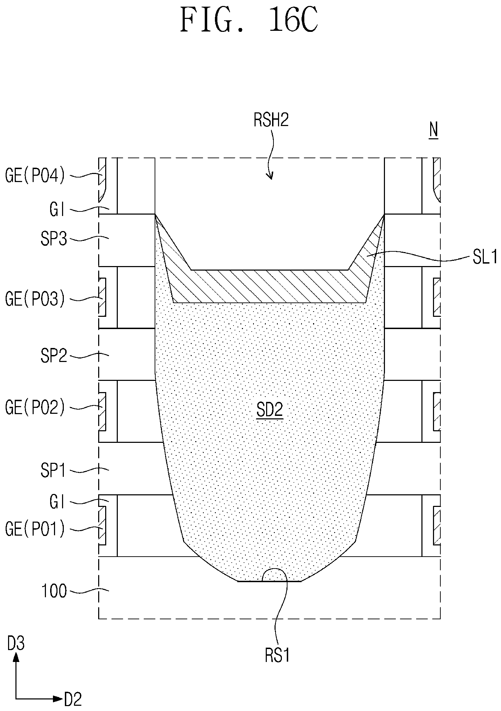

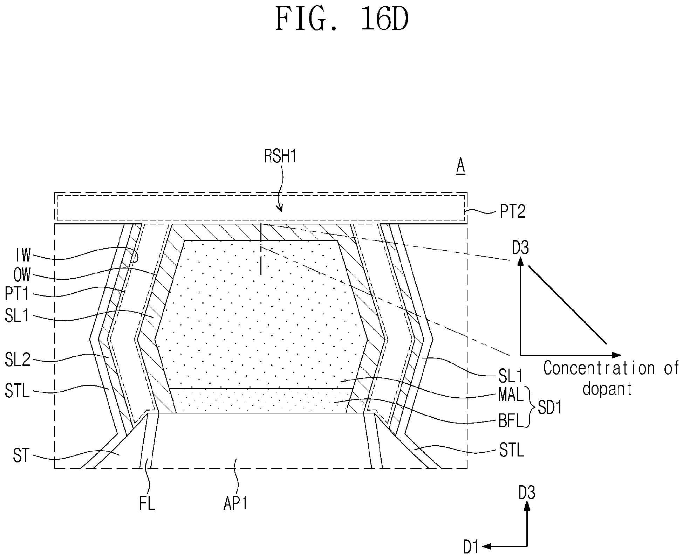

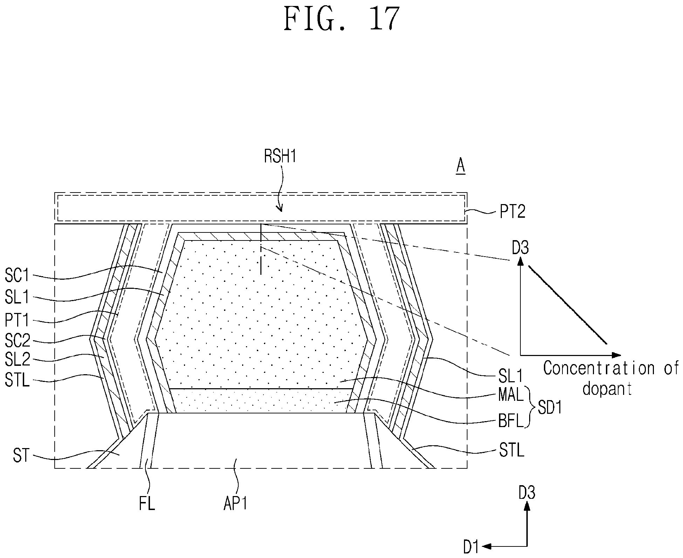

FIGS. 12D and 12E illustrate enlarged views showing section M of FIG. 12A and section N of FIG. 12B, respectively. FIGS. 15B and 15C illustrate cross-sectional views showing a method of forming the first source/drain pattern SD1 depicted in FIG. 6. FIGS. 16B and 16C illustrate cross-sectional views showing a method of forming the second source/drain pattern SD2 depicted in FIG. 7. FIGS. 16D and 17 illustrate cross-sectional views showing a method of forming the first source/drain pattern SD1 depicted in FIG. 8.

Referring to FIGS. 9A and 9B, a substrate 100 may be provided which includes a PMOSFET region PR and an NMOSFET region NR. Active layers ACL and sacrificial layers SAL may be alternately formed on the substrate 100. The active layers ACL may include one of silicon (Si), germanium (Ge), and silicon-germanium (SiGe), and the sacrificial layers SAL may include another of silicon (Si), germanium (Ge), and silicon-germanium (SiGe).

The sacrificial layer SAL may include a material having an etch selectivity with respect to the active layer ACL. For example, the active layers ACL may include silicon (Si), and the sacrificial layers SAL may include silicon-germanium (SiGe). Each of the sacrificial layers SAL may have a germanium concentration of about 10 at% to about 50 at%.

Mask patterns may be correspondingly formed on the PMOSFET and NMOSFET regions PR and NR of the substrate 100. The mask pattern may have a linear or bar shape that extends in a second direction D2.

A patterning process may be performed in which the mask patterns are used as an etching mask to form a trench TR that defines a first active pattern AP1 and a second active pattern AP2. The first active pattern AP1 and the second active pattern AP2 may be respectively formed on the PMOSFET region PR and the NMOSFET region NR.

A stack pattern STP may be formed on each of the first and second active patterns AP1 and AP2. The stack pattern STP may include the active layers ACL and the sacrificial layers SAL that are alternately stacked. During the patterning process, the stack pattern STP may be formed simultaneously with the first and second active patterns AP1 and AP2.

A device isolation layer ST may be formed to fill the trench TR. The device isolation layer ST may be formed on a liner layer FL. For example, a dielectric layer may be formed on a front surface of the substrate 100 to cover the stack patterns STP and the first and second active patterns AP1 and AP2. The dielectric layer may be recessed until the stack patterns STP are exposed, and thus the device isolation layer ST may be formed.

The device isolation layer ST may include a dielectric material, such as a silicon oxide layer. The stack patterns STP may be exposed upwardly from the device isolation layer ST. For example, the stack patterns STP may vertically protrude upwards from the device isolation layer ST.

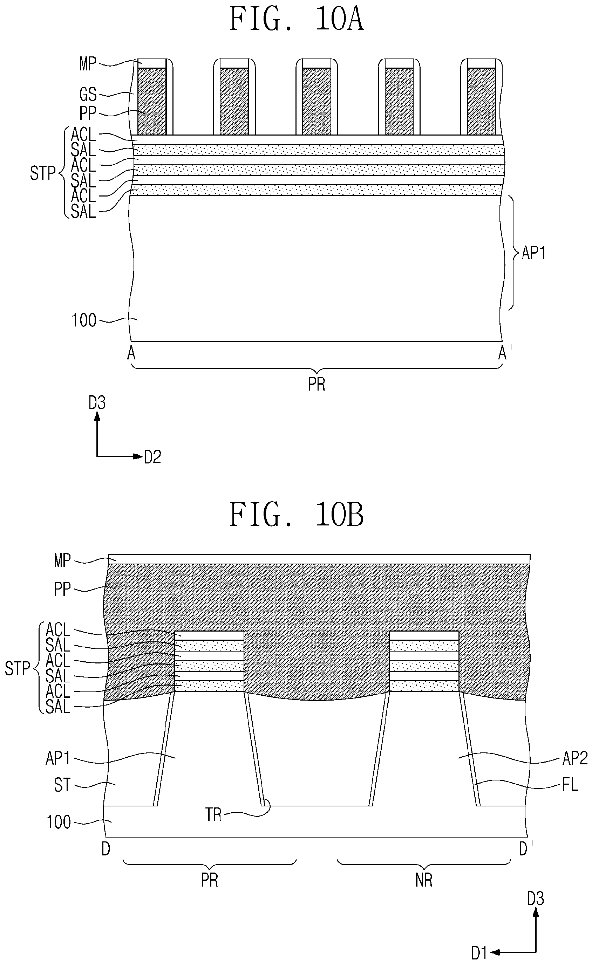

Referring to FIGS. 10A and 10B, sacrificial patterns PP may be formed on the substrate 100 to run across the stack patterns STP. Each of the sacrificial patterns PP may be formed to have a linear or bar shape that extends in a first direction D1. The sacrificial patterns PP may be arranged at a first pitch along the second direction D2.

For example, the formation of the sacrificial patterns PP may include forming a sacrificial layer on the front surface of the substrate 100, forming hardmask patterns MP on the sacrificial layer, and using the hardmask patterns MP as an etching mask to pattern the sacrificial layer. The sacrificial layer may include polysilicon.

A pair of gate spacers GS may be formed on opposite sidewalls of each of the sacrificial patterns PP. The formation of the gate spacers GS may include conformally forming a gate spacer layer on the front surface of the substrate 100 and anisotropically etching the gate spacer layer. The gate spacer layer may include at least one selected from SiCN, SiCON, and SiN. Alternatively, the gate spacer layer may be a multiple layer including at least two selected from SiCN, SiCON, and SiN.

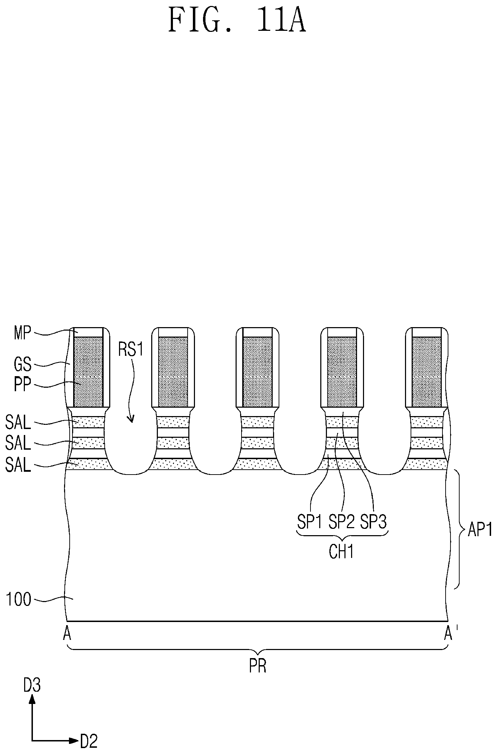

Referring to FIGS. 11A to 11C, first recesses RS1 may be formed in the stack pattern STP on the first active pattern AP1. Second recesses RS2 may be formed in the stack pattern STP on the second active pattern AP2. During the formation of the first and second recesses RS 1 and RS2, the device isolation layer ST may further be recessed on opposite sides of each of the first and second active patterns AP1 and AP2 (see FIG. 11C).

For example, the hardmask patterns MP and the gate spacers GS may be used as an etching mask to etch the stack pattern STP on the first active pattern AP1 to form the first recesses RS 1. The first recess RS 1 may be formed between a pair of sacrificial patterns PP. The formation of the first recess RS1 may include additionally performing a selective etching process on the exposed sacrificial layers SAL. Therefore, the first recess RS1 may have a wavy inner wall.

The second recesses RS2 in the stack pattern STP on the second active pattern AP2 may be formed by the same method used for the formation of the first recesses RS 1. The formation of the second recess RS2 may further include forming an inner spacer ISP in an area where the sacrificial layer SAL is recessed. Thus, an inner wall of the second recess RS2 may not have the same wavy shape as that of the inner wall of the first recess RS1.

The active layers ACL may be formed into first, second, and third semiconductor patterns SP1, SP2, and SP3 that are sequentially stacked between neighboring first recesses RS1. The active layers ACL may be formed into first, second, and third semiconductor patterns SP1, SP2, and SP3 that are sequentially stacked between neighboring second recesses RS2. Thus, the first semiconductor pattern SP1 may be formed at bottom of the semiconductor patterns SP1 to SP3, and the third semiconductor pattern SP3 may be formed at top of the semiconductor patterns SP1 to SP3. A first channel pattern CH 1 may be constituted by the first, second, and third semiconductor patterns SP 1, SP2, and SP3 between neighboring first recesses RS1. A second channel pattern CH2 may be constituted by the first, second, and third semiconductor patterns SP1, SP2, and SP3 between neighboring second recesses RS2.

Referring to FIGS. 12A to 12E, first source/drain patterns SD1 may be correspondingly formed in the first recesses RS1. FIGS. 12D and 12E illustrate enlarged views showing section M of FIG. 12A and section N of FIG. 12B, respectively.

Referring to FIGS. 12A and 12D, a selective epitaxial growth (SEG) process may be performed in which the inner wall of the first recess RS 1 is used as a seed layer to form a buffer layer BFL. The buffer layer BFL may be grown from a seed, or the substrate 100 and the first, second, and third semiconductor patterns SP1, SP2, and SP3 exposed by the first recess RS 1. For example, the SEG process may include chemical vapor deposition (CVD) or molecular beam epitaxy (MBE).

The buffer layer BFL may include a semiconductor element (e.g., SiGe) whose lattice constant is greater than that of a semiconductor element of the substrate 100. The buffer layer BFL may contain germanium (Ge) whose concentration is relatively low. In some implementations, the buffer layer BFL may not include germanium (Ge), but include only silicon (Si). The germanium concentration of the buffer layer BFL may range from about 0 at% to about 30 at%.

The buffer layer BFL may undergo a SEG process to form a main layer MAL. The main layer MAL may be formed to completely fill the first recess RS 1. The main layer MAL may contain germanium (Ge) whose concentration is relatively high. For example, the germanium concentration of the main layer MAL may range from about 30 at% to about 70 at%.

During the formation of the buffer layer BFL and the main layer MAL, impurities (e.g., boron, gallium, or indium) may be in-situ implanted to allow the first source/drain pattern SD1 to have a p-type. Alternatively, after the formation of the first source/drain pattern SD1, impurities may be implanted into the first source/drain pattern SD1.

Second source/drain patterns SD2 may be correspondingly formed in the second recesses RS2. For example, a selective epitaxial growth (SEG) process may be performed such that the inner wall of the second recess RS2 is used as a seed to form the second source/drain pattern SD2. For example, the second source/drain pattern SD2 may include the same semiconductor element (e.g., Si) as that of the substrate 100.

During the formation of the second source/drain pattern SD2, impurities (e.g., phosphorus, arsenic, or antimony) may be in-situ implanted to allow the second source/drain pattern SD2 to have an n-type. Alternatively, after the formation of the second source/drain pattern SD2, impurities may be implanted into the second source/drain pattern SD2.

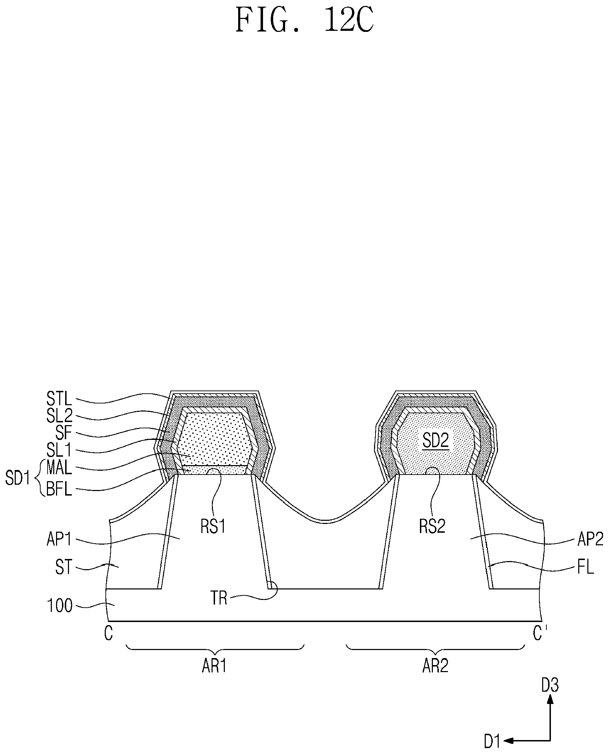

Referring to FIGS. 12C and 12D, a first silicon layer SL1 may be formed on the buffer layer BFL and the main layer MAL. The first silicon layer SL1 may cover a top surface and opposite sidewalls of the first source/drain pattern SD1. An etch pattern SF may be formed on the first silicon layer SL1, and a second silicon layer SL2 may be formed on the etch pattern SF. The etch pattern SF may extend from a top surface toward opposite sidewalls of the first silicon layer SL1. The second silicon layer SL2 may extend from a top surface toward opposite sidewalls of the etch pattern SF. The etch pattern SF may be formed between the first silicon layer SL1 and the second silicon layer SL2. The etch pattern SF may have an average thickness greater than that of each of the first and second silicon layers SL1 and SL2.

The etch pattern SF may include silicon-germanium (SiGe). The etch pattern SF may have a germanium concentration greater than that of each of the first and second silicon layers SL1 and SL2. The etch pattern SF may include a material having an etch selectivity with respect to the first and second silicon layers SL1 and SL2. Neither the first silicon layer SL1 nor the second silicon layer SL2 may include germanium (Ge). The first silicon layer SL1 and the second silicon layer SL2 may include substantially the same material.

A stop layer STL may be formed on the second silicon layer SL2. The stop layer STL may extend from a top surface toward opposite sidewalls of the second silicon layer SL2. The stop layer STL may include a material having an etch selectivity with respect to a first interlayer dielectric layer 110 which will be discussed below. For example, the stop layer STL may include a silicon nitride (SiN) layer.

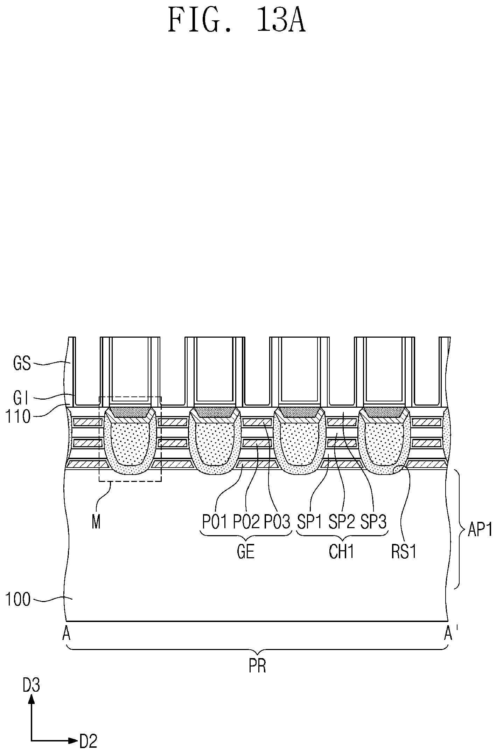

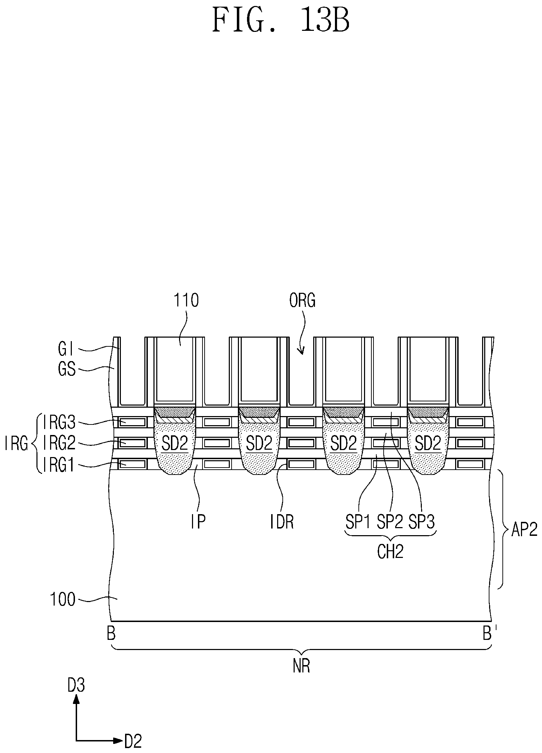

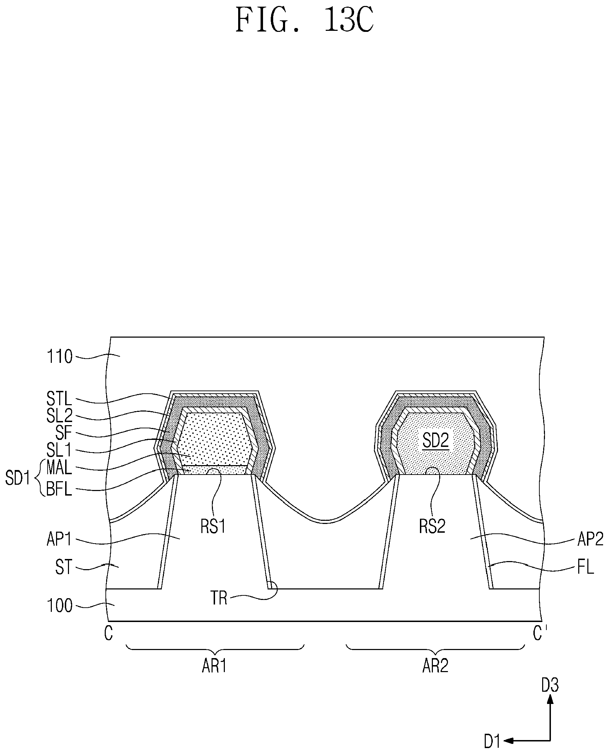

Referring to FIGS. 13A to 13D, a first interlayer dielectric layer 110 may be formed to cover the first and second source/drain patterns SD1 and SD2, the hardmask patterns MP, and the gate spacers GS. For example, the first interlayer dielectric layer 110 may include a silicon oxide layer.

The first interlayer dielectric layer 110 may be planarized until top surfaces of the sacrificial patterns PP are exposed. An etch-back or chemical mechanical polishing (CMP) process may be used to planarize the first interlayer dielectric layer 110. The hardmask patterns MP may all be removed during the planarization process. As a result, the first interlayer dielectric layer 110 may have a top surface coplanar with those of the sacrificial patterns PP and those of the gate spacers GS.

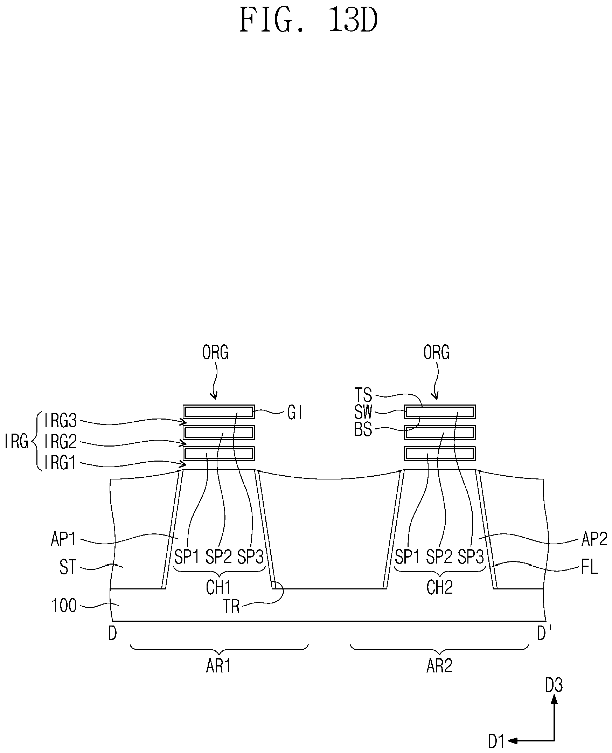

The exposed sacrificial patterns PP may be selectively removed. The removal of the sacrificial patterns PP may form an outer region ORG that exposes the first and second channel patterns CH1 and CH2 (see FIG. 13D). The removal of the sacrificial patterns PP may include performing a wet etching process using an etchant that selectively etches polysilicon.

The sacrificial layers SAL exposed through the outer region ORG may be selectively removed to form inner regions IRG (see FIG. 13D). For example, an etching process that selectively etches the sacrificial layers SAL may be performed such that only the sacrificial layers SAL may be removed while leaving the first, second, and third semiconductor patterns SP1, SP2, and SP3. The etching process may have a high etch rate with respect to silicon-germanium having a relatively high germanium concentration. For example, the etching process may have a high etch rate with respect to silicon-germanium whose germanium concentration is greater than about 10 at%, for example greater than or equal to 10 at%.

During the etching process, the sacrificial layers SAL may be removed from the PMOSFET region PR and the NMOSFET region NR. The etching process may be a wet etching process. An etching material used for the etching process may promptly etch the sacrificial layer SAL whose germanium concentrate is relatively high.

Referring to FIG. 13D, as the sacrificial layers SAL are selectively removed, the stacked first, second, and third semiconductor patterns SP1, SP2, and SP3 may remain on each of the first and second active patterns AP1 and AP2. The removal of the sacrificial layers SAL may form first, second, and third inner regions IRG1, IRG3, and IRG3.

For example, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring to FIGS. 13A to 13D, a gate dielectric layer GI may be formed on the exposed first, second, and third semiconductor patterns SP1, SP2, and SP3. The gate dielectric layer GI may be formed to surround each of the first, second, and third semiconductor patterns SP1, SP2, and SP3. The gate dielectric layer GI may be formed in each of the first, second, and third inner regions IRG1, IRG2, and IRG3. The gate dielectric layer GI may be formed in the outer region ORG.

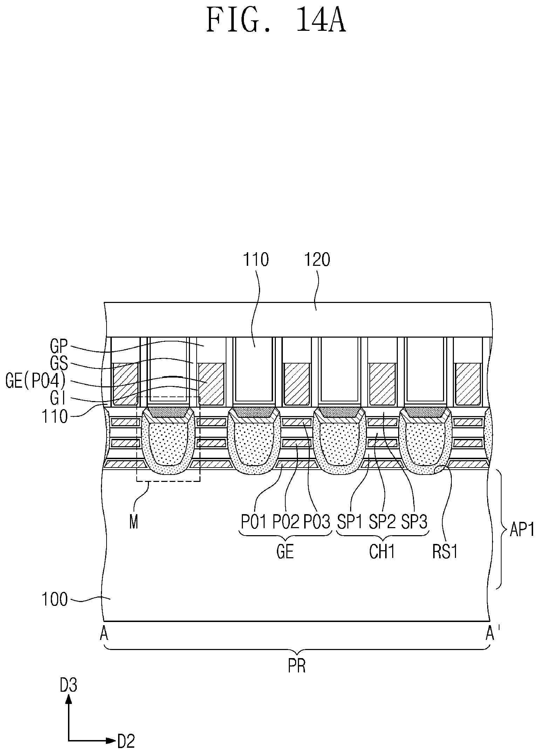

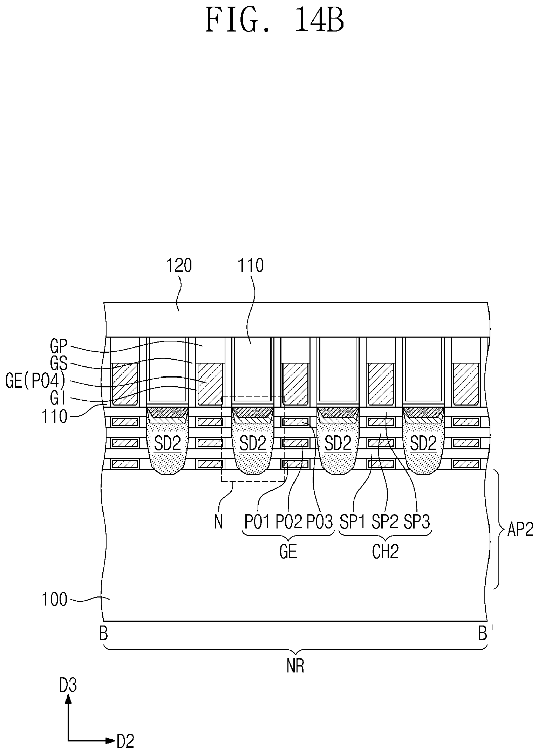

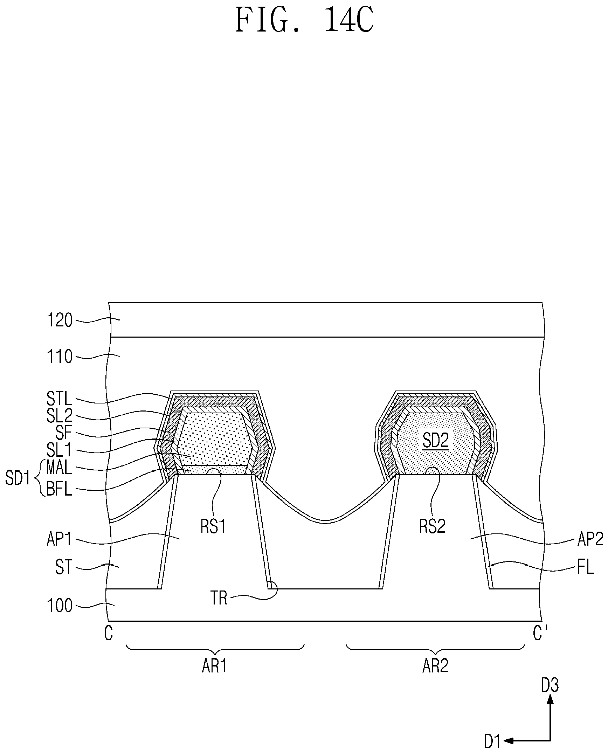

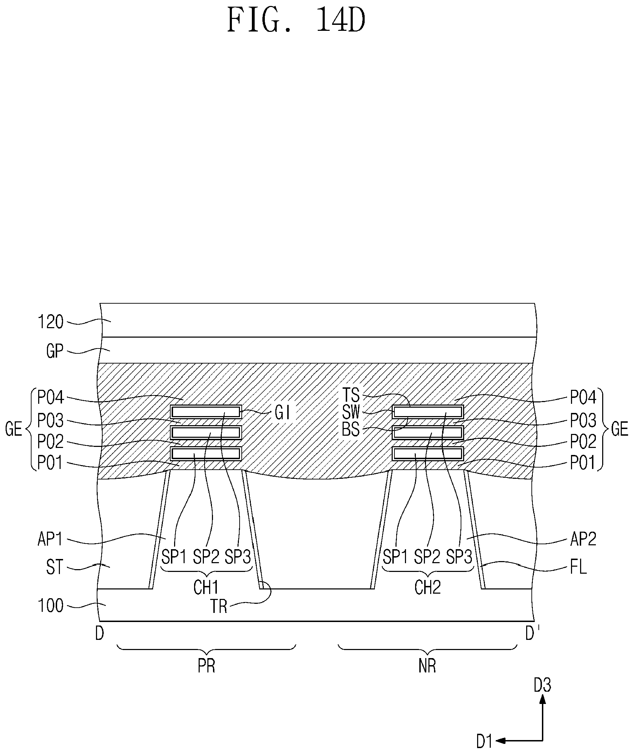

Referring to FIGS. 14A to 14D, a gate electrode GE may be formed on the gate dielectric layer GI. The gate electrode GE may be formed to fill the first, second, and third inner regions IRG1, IRG2, and IRG3 and the outer region ORG. The gate electrode GE may include a first part PO1, a second part PO2, and a third part PO3 that fill the first inner region IRG1, the second inner region IRG2, and the third inner region IRG3, respectively. The gate electrode GE may further include a fourth part PO4 that fills the outer region ORG. A gate capping pattern GP may be formed on the gate electrode GE.

Referring to FIGS. 14A to 14D, a second interlayer dielectric layer 120 may be formed on the first interlayer dielectric layer 110. The second interlayer dielectric layer 120 may include a silicon oxide layer.

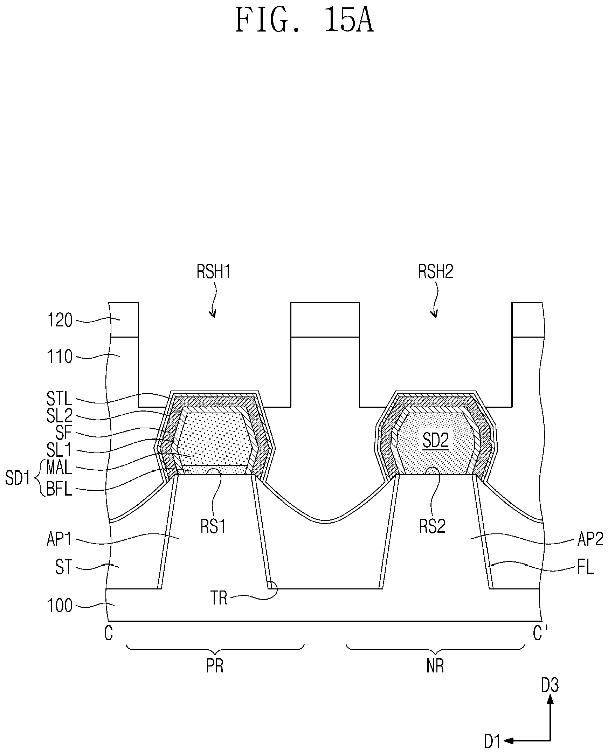

The formation of the active contact AC will be discussed in detail with reference to FIGS. 15A to 18. FIGS. 15B and 15C illustrate cross-sectional views showing a method of forming the first source/drain pattern SD1 depicted in FIG. 6.

Referring to FIGS. 15A to 15C, the first and second interlayer dielectric layers 110 and 120 may be etched to form first and second recess holes RSH1 and RSH2 each of which exposes the stop layer STL. The first recess hole RSH1 may be formed on the PMOSFET region PR, and the second recess hole RSH2 may be formed on the NMOSFET region NR. Each of the first and second recess holes RSH1 and RSH2 may have a bottom surface at a level lower than that of a top surface of the stop layer STL and that of a top surface of the etch pattern SF. The stop layer STL may not be removed in the etching process.

After the formation of the first and second recess holes RSH1 and RSH2, the stop layer STL and the second silicon layer SL2 may be partially removed. For example, the removal action may be performed on only an upper portion of each of the stop layer STL and the second silicon layer SL2 that are exposed by the first and second recess holes RSH1 and RSH2. Therefore, there may not be removed the stop layer STL and the second silicon layer SL2 that are located at a position lower than a level of a lowermost surface of each of the first and second recess holes RSH1 and RSH2. The upper portion of each of the stop layer STL and the second silicon layer SL2 may be removed such that the first and second recess holes RSH1 and RSH2 may expose the etch pattern SF.

FIGS. 16B and 16C illustrate cross-sectional views showing a method of forming the second source/drain pattern SD2 depicted in FIG. 7. FIGS. 16D and 17 illustrate cross-sectional views showing a method of forming the first source/drain pattern SD1 depicted in FIG. 8.

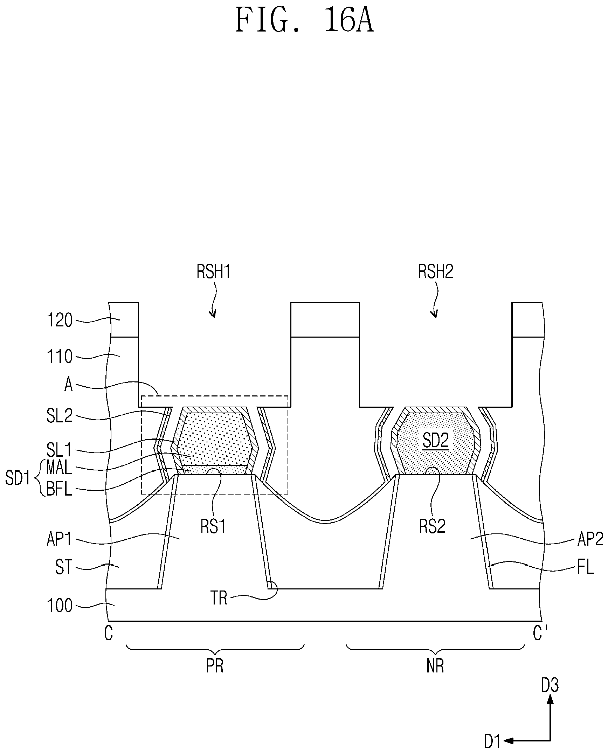

Referring to FIGS. 16A to 16D, a first etching process may be employed to remove the etch pattern SF exposed by the first and second recess holes RSH1 and RSH2. For example, the first etching process may be a wet etching process or a dry etching process. The dry etching process may use a gas including at least one of fluorine (F₂), chlorine (Cl₂), and hydrogen chloride (HCl), and the wet etching process may use a solution including at least one selected from hydrogen peroxide (H₂O₂), acetic acid (CH₃COOH), and hydrogen fluoride (HF).

Thus, the first and second recess holes RSH1 and RSH2 may expose the first and second silicon layers SL1 and SL2. Impurities may be implanted to dope an exposed outer wall OW of the first silicon layer SL1 and an exposed outer wall IW of the second silicon layer SL2. A plasma doping (PLAD) method may be employed to implant the outer walls OW and IW with the impurities. For example, impurity ions in a plasma state may be directly implanted into the outer walls OW and IW of the first and second silicon layers SL1 and SL2. The impurities on the PMOSFET region PR may include at least one of boron (B), gallium (Ga), and indium (In). The impurities on the NMOSFET region NR may include at least one of arsenic (As), phosphorus (P), and antimony (Sb).

Referring to FIG. 16D, the first and second silicon layers SL1 and SL2 may have their impurity concentrations that increase with decreasing distance from their respective outer walls OW and IW. As the impurities are implanted, there may be a reduction in contact resistance between a subsequently described active contact AC and the first and second source/drain patterns SD1 and SD2.

Referring to FIG. 17, a first silicide layer SC1 may be formed on the exposed outer wall OW of the first silicon layer SL1. A second silicide layer SC2 may be formed on the exposed outer wall IW of the second silicon layer SL2. For example, the first silicide layer SC1 may be formed by depositing a metallic material on the exposed outer wall OW of the first silicon layer SL1. The second silicide layer SC2 may be formed by depositing a metallic material on the exposed outer wall IW of the second silicon layer SL2. The metallic material may include at least one of titanium, tantalum, tungsten, nickel, and cobalt. A chemical vapor deposition (CVD) process may be used to deposit the metallic material.

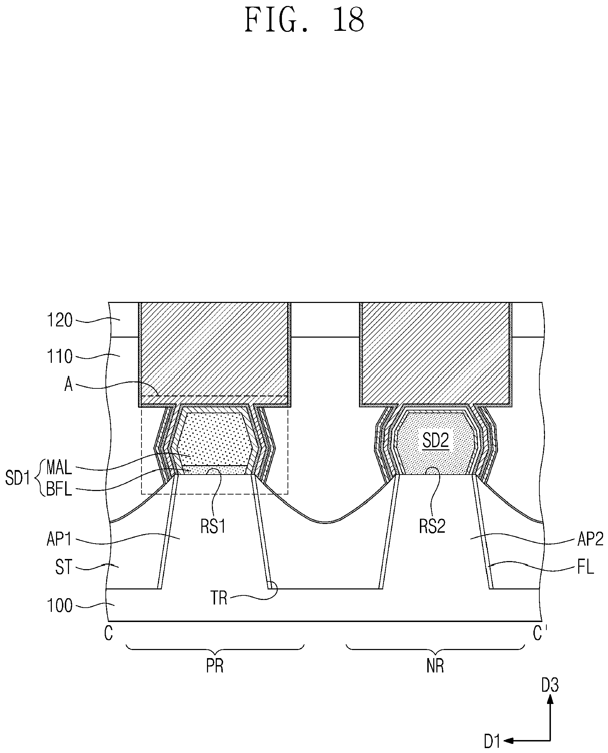

Referring to FIGS. 8 and 18, an active contact AC may be formed in each of the first and second recess holes RSH1 and RSH2. The formation of the active contact AC may include forming a barrier pattern BM and a forming a conductive pattern FM on the barrier pattern BM. The barrier pattern BM may be conformally formed to include a metal layer and a metal nitride layer. The metal layer may include at least one of titanium, tantalum, tungsten, nickel, cobalt, and platinum. The metal nitride layer may include at least one of a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer. The conductive pattern FM may include a low-resistance metal. For example, the conductive pattern FM may include at least one metal, for example one or more of aluminum, copper, tungsten, molybdenum, and cobalt.

A gate contact GC may be formed to penetrate the second interlayer dielectric layer 120 and the gate capping pattern GP to come into electrical connection with the gate electrode GE. The formation of the gate contact GC may be the same as the formation of the active contact AC.

Separation structures DB may be correspondingly formed on first and second boundaries BD1 and BD2 of the single height cell SHC. The separation structure DB may extend from the second interlayer dielectric layer 120 through the gate electrode GE into the active pattern AP1 or AP2. The separation structure DB may include a dielectric material, such as a silicon oxide layer or a silicon nitride layer.

A third interlayer dielectric layer 130 may be formed on the active contacts AC and the gate contacts GC. A first metal layer M1 may be formed in the third interlayer dielectric layer 130. A fourth interlayer dielectric layer 140 may be formed on the third interlayer dielectric layer 130. A second metal layer M2 may be formed in the fourth interlayer dielectric layer 140.

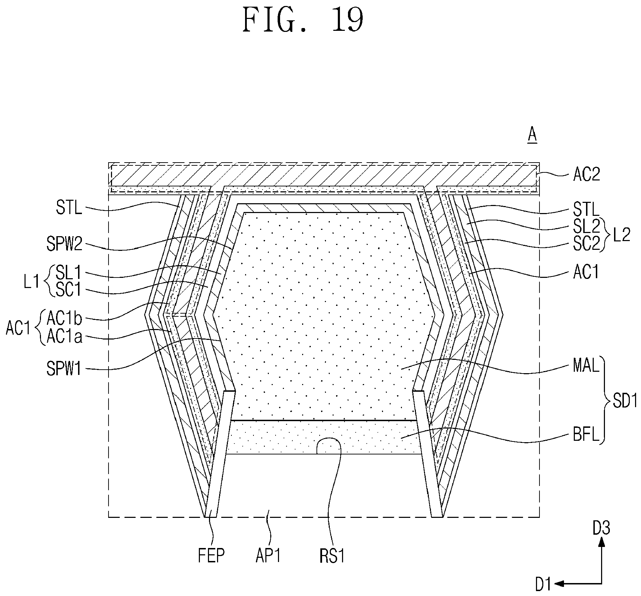

FIG. 19 illustrates an example enlarged view showing section A of FIG. 5C. Referring to FIG. 19, each of the first and second active patterns AP1 and AP2 may be provided on its sidewall with a fence part FEP that protrudes upwardly from the device isolation layer ST. The fence part FEP may be a portion of the gate spacer GS that remains on the sidewall of each of the first and second active patterns AP1 and AP2. For example, the fence part FEP may include the same dielectric material as that of the gate spacer GS.

The fence part FEP may cover a lower sidewall of each of the first and second source/drain patterns SD1 and SD2. A top surface of the fence part FEP may be higher than a bottom surface of the first recess RS1. A sidewall of the first layer L1 may be in direct contact with the fence part FEP. At least a portion of the second layer L2 may be in contact with the fence part FEP.

The fence part FEP may be in direct contact with a bottom surface of each of the first and second silicide layers SC1 and SC2. The fence part FEP may be in direct contact with a bottom surface of each of the first and second silicon layers SL1 and SL2. The fence part FEP may be in direct contact with a bottom surface of the barrier pattern BM and a bottom surface of the conductive pattern FM.

In a semiconductor device, an active contact may cover a top surface and opposite sidewalls of a source/drain pattern. A first layer may be formed between the source/drain pattern and the active contact, and a second layer may be formed spaced apart from the source/drain pattern across the active contact. Each of the first and second layers may include a silicide layer and a silicon layer. Therefore, an increased contact area may be provided between the active contact and the source/drain pattern, and this configuration may reduce a contact resistance between the active contact and the source/drain pattern. In addition, the contact resistance may be reduced by doping impurities into a contact surface between the first layer and the active contact. As a result, a semiconductor device may have increased reliability and improved electrical properties.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations and even initially be claimed as such, one or more features from a claimed combination can in some cases be excised from the combination, and the claimed combination may be directed to a subcombination or variation of a subcombination. In general, as used herein, an element or region that is described as "covering" another element of region may completely, substantially completely, or partially cover the other element or region.

Although the concepts disclosed herein have been discussed with reference to accompanying figures, it will be understood that various changes in form and details may be made therein. It therefore will be understood that the implementations described above are just illustrative but not limitative in all aspects.

## Claims

1. A semiconductor device, comprising:
a substrate that includes an active region;
an active pattern on the active region;
a source/drain pattern on the active pattern;
an active contact that extends from a top surface of the source/drain pattern to a sidewall of the source/drain pattern, wherein the active contact includes a first part that covers the sidewall of the source/drain pattern and a second part that covers the top surface of the source/drain pattern;
a first layer between the source/drain pattern and the first part; and
a second layer separated from the first layer and across the first part,
wherein each of the first layer and the second layer includes a silicide layer.

2. The semiconductor device of claim 1, wherein the first layer includes:
a first silicon layer that covers the top surface and opposite sidewalls of the source/drain pattern; and
a first silicide layer on the first silicon layer.

3. The semiconductor device of claim 2, wherein the first silicon layer has an impurity concentration that increases with decreasing distance from the silicide layer.

4. The semiconductor device of any preceding claim, wherein the second layer includes:
a second silicide layer that covers an outer sidewall of the first part; and
a second silicon layer on the second silicide layer.

5. The semiconductor device of any preceding claim, wherein each silicide layer includes at least one of titanium-silicide, tantalum-silicide, tungsten-silicide, nickel-silicide, and cobalt-silicide.

6. The semiconductor device of any preceding claim, wherein the active contact includes a conductive pattern and a barrier pattern that surrounds the conductive pattern, and
wherein the barrier pattern is between the conductive pattern and the first layer and between the conductive pattern and the second layer.

7. The semiconductor device of claim 6, wherein the barrier pattern covers a top surface and opposite sidewalls of each silicide layer.

8. The semiconductor device of any preceding claim, further comprising a stop layer on a sidewall of the second layer,
wherein the stop layer includes SiN.

9. The semiconductor device of any preceding claim, wherein each silicide layer has an impurity concentration that increases with decreasing distance from the active contact.

10. A semiconductor device, comprising:
a substrate that includes an active region;
an active pattern on the active region;
a source/drain pattern on the active pattern; and
an active contact electrically connected to the source/drain pattern,
wherein a sidewall of the source/drain pattern includes a first surface and a second surface,
wherein the first surface intersects the second surface to form a vertex of the source/drain pattern,
wherein the active contact includes a first extension that covers the first surface and a second extension that covers the second surface,
wherein the first extension has a first slope and extends along the first surface,
wherein the second extension has a second slope and extends along the second surface, and
wherein one slope of the first slope and the second slope is a positive slope, and the other slope of the first slope and the second slope is a negative slope.

11. The semiconductor device of claim 10, further comprising:
a first silicon layer between the active contact and the sidewall of the source/drain pattern; and
a second silicon layer separated from the source/drain pattern and across the first extension and the second extension.

12. The semiconductor device of claim 11, wherein a silicide layer is between the first silicon layer and the active contact and between the second silicon layer and the active contact.

13. The semiconductor device of claim 12, wherein the silicide layer includes at least one of titanium-silicide, tantalum-silicide, tungsten-silicide, nickel-silicide, and cobalt-silicide.

14. The semiconductor device of claim 12 or claim 13, wherein the active contact includes a conductive pattern and a barrier pattern that surrounds the conductive pattern, and
wherein the barrier pattern is between the silicide layer and the conductive pattern.

15. The semiconductor device of any of claims 12 to 14, wherein the silicide layer has an impurity concentration that increases with decreasing distance from the active contact.
